Europäisches Patentamt

European Patent Office

Office européen des brevets

(11) Veröffentlichungsnummer: **0 258 725 B1**

## (12) EUROPÄISCHE PATENTSCHRIFT

(45) Veröffentlichungstag der Patentschrift: **07.07.93**

(21) Anmeldenummer: **87111904.6**

(22) Anmeldetag: **17.08.87**

(51) Int. Cl.⁵: **H03M 1/22**, G01D 5/24

(54) **Kapazitiver Drehgeber zum Steuern und Positionieren von bewegten Gegenständen.**

(30) Priorität: **02.09.86 DE 3629792**
**04.11.86 DE 3637529**

(43) Veröffentlichungstag der Anmeldung:
**09.03.88 Patentblatt 88/10**

(45) Bekanntmachung des Hinweises auf die
Patenterteilung:
**07.07.93 Patentblatt 93/27**

(84) Benannte Vertragsstaaten:
**AT BE CH DE ES FR GB IT LI NL SE**

(56) Entgegenhaltungen:
**FR-A- 2 366 540**
**GB-A- 2 176 013**
**US-A- 3 172 023**
**US-A- 4 092 579**

(73) Patentinhaber: **Hengstler GmbH**
**Postfach 1151**
**W-7209 Aldingen(DE)**

(72) Erfinder: **Krumholz, Claus-Peter, Dipl.Ing.**
**Forchenweg 11**
**W-7208 Spaichingen(DE)**
Erfinder: **Walter,Thomas,Dipl.Ing.**
**Am Gerberbach 2**
**7600 Offenburg(DE)**

(74) Vertreter: **Riebling, Peter, Dr.-Ing., Patentan-**
**walt**
**Rennerle 10, Postfach 31 60**
**W-8990 Lindau/B. (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen kapazitiven Drehgeber nach dem Oberbegriff des Patentanspruchs 1.

Ein Drehgeber der eingangs genannten Art ist in der US-A-4 092 579 dargestellt. Bei diesem bekannten Drehgeber sind auf der Statorauskoppelseite des Meßkondensators verschiedene, voneinander isolierte, nach einer mathematischen Formel strukturierte, Elektroden vorgesehen, die im Zusammenhang mit den Rotorflächen einen Kondensator mit sinusförmiger Flächenüberdeckung bilden. Bei diesem bekannten Drehgeber ist es jedoch nicht möglich, neben der Grobspur mittels einer gleichzeitig vorgesehenen Feinspur eine größere Genauigkeit zu erreichen. Aus der US-A-4 092 579 ist weiterhin bekannt, daß die konzentrischen Beläge auf Rotor und Stator so angeordnet werden können, daß eine Sinus- und/oder Cosinus-Funktion der Koppelkapazität bei der Drehung des Rotors erzeugt wird. Aus US-A-4 092 579 ist ferner zu entnehmen, daß das Grobmeßsystem auch mehrphasig ausgebildet sein kann. Damit ist jedoch nicht die Kombination eines Grob- mit einem Feinmeßsystem bekannt.

Ein weiterer Drehgeber ist mit der US-A-4 238 781 bekannt geworden. Nachteil dieses bekannten Drehgebers ist, daß eine Phasenverschiebung eines Ausgangssignals in Abhängigkeit vom Drehwinkel ausgewertet wird, was zu einer relativ aufwendigen Auswerteschaltung führt, die überdies wenig genau ist. Bei diesem bekannten Drehgeber handelt es sich um einen Geber zur Anwendung in einem Elektrizitätszähler, der für die Auslesung des Stromverbrauchs in Haushalten verwendet werden soll und bei dem es lediglich darum geht, zehn Ziffern zu unterscheiden und in digitaler Form an einem Ausgang bereit zu stellen.

Im übrigen zeigt die US-A-4 238 781 keinen genau sinusförmigen Kapazitätsverlauf der Koppelkondensatoren, weil die Belegungsdichte der Beläge auf dem einen Stator über den Drehwinkel gesehen nicht den hierzu geeigneten Verlauf besitzt. Damit ist die erreichbare Genauigkeit eingeschränkt. Darüber hinaus gilt für die Beläge des Rotors, daß diese keine zwei Sinushalbwellen erzeugen können, weil sie sich nicht über den Drehwinkel von 180° erstrecken. Dies beeinträchtigt zusätzlich die erreichbare Genauigkeit. Dort wird ein Differentialsignal aus zwei verschiedenen kreisringförmigen Belägen der Statorscheibe gebildet. Damit wird zwar die Auflösung erhöht, aber die Vorteile der Kombination eines Großmeßsystems mit einem Feinmeßsystem (Beseitigung von Skalenfehlern, von lokalen Defekten und von Verkippungen) werden nicht erreicht.

Ein weiterer Drehgeber der genannten Art ist aus der US-A-3 172 023 bekannt. Der dort bekannte Drehgeber stellt jedoch nur einen variablen Kondensator mit sinusförmigem Kapazitätsverlauf dar, wobei durch Verdrehen des Rundrohrs unterschiedliche aktive Flächen des Kondensators geschaffen werden. Bei diesem bekannten Drehgeber ist jedoch die Ausbildung einer Grob- und Feinspur nicht ersichtlich. Es ist lediglich von verschiedenen Drehgeschwindigkeiten die Rede, was nur bedeutet, daß der Resolver für Eil- und Kriechgang-Anwendungen geeignet ist.

Aus der FR-A-2 366 540 ist eine planare Struktur mit spiralförmigen Leiterbahnen bekannt, die ebenfalls als Drehgeber geeignet erscheint. Die Form der Elektroden ist so gestaltet, daß sich ein sinusförmiger Verlauf der Kapazität zwischen dem rotierenden Objekt und den Elektroden ergibt, ohne daß jedoch eine erhöhte Auflösung mittels einer Grobspur und einer dazu parallelen Feinspur erreicht werden kann.

Ein weiterer kapazitiver Drehgeber ist aus der DE-B-1 248 961 bekannt. Dort sind die Beläge auf der Rotorober- und Rotorunterseite durchgehend und jeweils gleich ausgebildet, so daß insoweit kein nebeneinander angeordnetes Grob- und Feinmeßsystem gebildet wird. Im übrigen erlaubt der bekannte Drehgeber keine kontinuierliche Messung über einen Meßwinkel von 360°, weil insbesondere nur eine einzige Ansteuerspannung und keine überlagerte Sinus-Kosinus-Spannung verwendet wird. Im weiteren ist auch ein schwankendes Meßergebnis bei dem bekannten Drehgeber zu befürchten, da sich beim Übergang von einem Belag zu dem anderen Sprünge ergeben.

Der Erfindung liegt daher die Aufgabe zugrunde, einen Drehgeber der eingangs genannten Art so weiterzubilden, daß er bei geringerem Schaltungsaufwand eine wesentlich größere Auflösung bei überlegener Genauigkeit hat.

Zur Lösung der gestellten Aufgabe ist die Erfindung dadurch gekennzeichnet, daß die Beläge so auf dem Rotor und den Statoren angeordnet isnd, daß sich mindestens zwei kreisringförmige, konzentrische Bereiche ergeben, von denen der eine Bereich die Meßspur eines Großmeßsystems und der andere Bereich die Meßspur eines Feinmeßsystems bidlet, wobei die Beläge des Feinmeßsystems periodisch bezüglich eines Bruchteils von 360° auf kreisringförmigen Bahnen von Rotor und Statoren angeordnet sind, während die Beläge des Großmeßsystems periodisch bezüglich 360° sind, daß die von einander zugeordneten Belägen von Rotor und Statoren entstehenden Koppelkapazitäten einen Verlauf über die Verdrehung der Welle ausweisen, der stückweise sinusförmig ist und daß durch Addition mehrerer gegenseitig verschobener und mit unterschiedlichem Vorzeichen versehener stückweise sinusförmig verlaufender Kapazitätsverläufe ein etwa rein sinusförmiger Kapazitätsverlauf mit einer Periode von 360°/ni entsteht, wobei ni als ganze natürliche Zahl die Polpaarzahl der jeweiligen Meßspur angibt und der Index i die Anzahl der Meßspuren durchläuft.

Der - an sich bekannten Grobspur - wird also eine Feinspur, hinzugefügt, die in der Kombination mit der Grobspur die vorgenannte gestellte Aufgabe löst.

Mit der Hinzufügung einer Feinspur zu der ansich bekannten Grobspur erhält der Drehgeber nach der vorliegenden Erfindung überlegene Eigenschaften, denn es werden damit Fehler-Korrektur-Mechanismen ermöglicht, wie z.B. die Ausmittelung statistischer Skalenfehler und lokaler Defekte, und vor allem eine Selbstkompensation von Verkippungen der Rotorscheibe in Bezug zu den beiden Statorscheiben.

Während derartige Fehler (Skalenfehler, lokale Defekte und Verkippungen) bei dem Drehgeber nach der US 4 238 781 eine schwerwiegende Beeinträchtigung der Genauigkeit hervorriefen, können nach der technischen Lehre der vorliegenden Erfindung derartige Fehlereinflüsse berücksichtigt und damit ausgeschieden werden.

In einer bevorzugten Ausführungsform ist eine Welle ist über zwei Kugellager drehbar in das Gehäuse eingebaut. Mit ihr ist über eine Nabe eine runde Scheibe, der Rotor, fest verbunden.

Der Rotor befindet sich parallel zu und - durch Luftspalte von ihnen getrennt - zwischen zwei Statorscheiben, die fest mit dem Gehäuse verbunden sind.

Rotor und Statoren bestehen aus isolierendem Basismaterial. Auf den Oberflächen von Rotor und Statoren sind flächig Leiterbahnmuster angebracht. Die Leiterbahnmuster der beiden Statoren werden über Kabel o.ä. mit der Elektronik verbunden, die sich z.B. auf der SMD-Platine befindet.

Es wird eine dreischeibige Anordnung beschrieben.

Stator , Rotor und Stator folgen aufeinander. Zwischen dem einen Stator und dem Rotor liege der Meßluftspalt. Zwischen Rotor und dem anderen Stator liege der Auskoppelluftspalt. Auf verschiedenen Radien seien jeweils auf allen drei Scheiben kreisringförmige, konzentrische Bereiche (in unserem Fall 2) definiert, in denen geeignete Leiterbahnen angeordnet sind.

Jeder dieser Bereiche stellt eine Meßspur dar, in unserem Falle eine Grob- und eine Feinspur. Im Zusammenwirken mit seiner elektronischen Spurauswertung stellt jede Meßspur ein Meßsystem dar.

Insbesondere ist das Muster der Feinspur periodisch bezüglich eines Bruchteiles von 360°, bei der Grobspur bezüglich 360°.

Allgemein besitzt die i-te Spur einen Meßbereich von 360°/ni, wobei $n_i$ natürlich ist und die Polpaarzahl der Spur angibt. Dabei liefern jeweils um Vielfache von 360° /$n_i$ versetzte Winkel dasselbe Meßergebnis.

Im Zusammenwirken der Spuren ist es möglich, den großen Meßbereich der einen Spur (Grobspur) mit der feinen Meßauflösung der anderen (Feinspur) so zu verbinden, daß ein Meßwandler mit feiner Auflösung und großem Meßbereich entsteht.

Die Leiterbahnmuster (Beläge) auf den sich gegenseitig zugewandten und durch den Meßluftspalt voneinander getrennten Seiten von dem einen Stator und dem Rotor sind Kondensatorbeläge eines Kondensatornetzwerkes, dessen Kapazitätswerte vom Drehwinkel abhängen (Meßkondensatoranordnung) . Die Leiterbahnmuster (Beläge) auf den sich gegenseitig zugewandten Seiten von Rotor und dem anderen Stator bilden Kondensatoren, deren Kapazitäten vom Drehwinkel idealerweise völlig unabhängig sind; deshalb erfüllen diese nur eine Auskoppelfunktion und der Luftspalt dazwischen wird Auskoppelluftspalt genannt.

Insgesamt stellen mindestens vier "Arten" von Belägen die Meßkondensatoranordnung dar. Beläge derselben "Art" befinden sich auf derselben Oberfläche und sind bezüglich des Mittelpunktes des Kreisringes, auf dem sich die Meßspur befindet, um ein vielfaches von 360°/$n_i$ verschoben; sie wirken gleichartig. Die Beläge derselben "Art" auf dem einen Stator werden über Durchkontaktierungen und Verbindungen auf der Rückseite gemeinsam mit einem elektrischen Signal verbunden; die Beläge des Rotors werden individuell durch diesen durchkontaktiert und in einem von der "Art" abhängigen Radiusbereich ausgekoppelt, wobei die Signale von individuellen Belägen derselben "Art" des Rotors erst nach der Auskopplung im anderen Stator elektrisch miteinander verbunden und elektronisch ausgewertet werden.

In der ausgeführten Konstruktion gibt es auf dem einen Stator vier "Arten" von Belägen, die identische Form besitzen und für jede "Art" j (von 1 bis 4) bezüglich eines "Nullpunktwinkels" um

$$j \times \frac{360°}{4 \times n_i} + k \times \frac{360°}{n_i}$$

verschoben angeordnet sind (k beliebig ganz).

Auf dem Rotor sind zwei "Arten "$\ell$ von Belägen um

$$\ell \ \times \ \frac{360°}{2 \times n_i} \ + k \ \times \ \frac{360°}{n_i}$$

gegen einen bezüglich des Rotors festen Nullpunktwinkel verschoben angeordnet.

Jede "Art" von Belag des einen Stators besitzt mit jeder anderen "Art" von Belag des Rotors eine Koppelkapazität, die einen Verlauf über die Verdrehung der Achse besitzt, der stückweise sinusförmig ist.

Durch Addition mehrerer gegenseitig verschobener und mit unterschiedlichen Vorzeichen versehener stückweise sinusförmiger Kapazitätsverläufe entstehen rein sinusförmige Kapazitätsverläufe mit der Periode $360° / n_i$.

Genau diese Verschiebungen entstehen durch die verschobenen Anordnungen der Muster, die Vorzeichenwechsel und Addition erfolgen elektronisch.

Der stückweise sinusförmige Kapazitätsverlauf wird durch die Formgebung der Beläge erzeugt.

Sie sind so zu formen, daß die Überlappungsflächen der Beläge sich bei Verdrehung stückweise sinusförmig ändern. Dafür gibt es unendlich viele Möglichkeiten. Die in der praktischen Ausführung gewählte beruht darauf, daß die Beläge des einen Stators innerhalb eines festzulegenden Winkelbereichs eine Belegungsdichte

dA (0) = konstant

besitzen, während für die Beläge des Rotors eine Belegungsdichte

$dA (0) = \sin (n_i \times \theta)$

innerhalb eines festzulegenden Winkelbereiches, vorzugsweise der Breite $180° / n_i$ gilt.

Auch umgekehrt ist eine konstante Belegungsdichte des Rotors und eine sinusabhängige Belegungsdichte des Stators möglich. Des weiteren können auch beide Beläge die Sinusabhängigkeit aufweisen.

Außerdem können zusätzliche Flächen addiert bzw. subtrahiert werden, die sich in ihren Wirkungen (effektive Überlagerungsflächen) gegenseitig aufheben.

Die (vier) Arten der Beläge des einen Stators werden mit elektrischen Signalen angesteuert. Diese Signale seien

1. $U_1 = U_0 \bmod \times \sin (n_i \times \phi)$
2. $U_2 = U_0 \bmod \times \cos (n_i \times \phi)$
3. $U_3 = U_0 \bmod \times (- \sin (n_i \times \phi))$
4. $U_4 = U_0 \bmod \times (-\cos (n_i \times \phi))$

wobei $U_0$ mod eine Modulationsspannung und 0 der sogenannte elektrische Winkel sei.

Die (zwei) Arten der Beläge des Rotors werden nach Auskopplung auf den anderen Stator gegenphasig an einen Vorverstärker angeschlossen. Dessen Ausgangssignal wird demoduliert. Zu diesem Ausgangssignal tragen die Signale über die kapazitive Kopplung bei

1. $\cos (n_i \times \theta)$
2. $- \sin (n_i \times \theta)$
3. $- \cos (n_i \times \theta)$
4. $\sin (n_i \times \theta)$

(bei einer willkürlich gewählten Beschaltung).

4

Es ist also:

$$U_{aus} = U_{0 \, mod} \times \sin (n_i \times \phi) \times \cos (n_i \times 0)$$

$$+ U_{0 \, mod} \times \cos (n_i \times \phi) \times (- \sin (n_i \times 0))$$

$$+ U_{0 \, mod} \times (- \sin (n_i \times \phi)) \times (- \cos \; (n_i \times 0))$$

$$+ U_{0 \, mod} \times (- \cos (n_i \times \phi)) \times \sin (n_i \times 0)$$

Demodulation und Umformung liefert:

$$U_{aus} = U_{0 \, demod} \; ^X$$

$$(1/2 \sin n_i \, (\phi - \theta) + 1/2 \sin n_i \, (\phi + 0)$$

$$- 1/2 \sin n_i \, (\theta - \phi) - 1/2 \sin n_i \, (\phi + 0)$$

$$+ 1/2 \sin n_i \, (\phi - 0) + 1/2 \sin n_i \, (\phi + 0)$$

$$- 1/2 \sin n_i \, (\theta - \phi) - 1/2 \sin n_i \, (\phi + \theta))$$

$$= U_{0 \, demod} \times 2 \times \sin n_i \; (\phi - \theta)$$

Das Ausgangssignal liefert also den Sinus der mit $n_i$ multiplizierten Differenz von mechanischem und elektronischem Winkel (mal einer Konstanten);
dieses Signal kann zu Null geregelt werden, indem $\phi$ geeignet verändert wird; dann gilt

$$0 = \phi$$

Wird $\phi$ nur für diskrete Werte dargestellt, so lässt sich U aus nur für diskrete Werte von $\phi$ zu Null regeln und gibt ansonsten die Abweichung von 0 an.

Da die Sinusfunktion in Nullpunktnähe annähernd linear ist, kann eine solche Regelung auch stabil sein; von den zwei Nulldurchgängen pro Periode ist nur einer bei Regelung stabil.

Die Regelempfindlichkeit und damit die Meßauflösung wächst linear mit der Polpaarzahl $n_i$, allerdings ist $\phi$ nur für $n_i = 1$ eindeutig, da bei höherer Polpaarzahl innerhalb eines mechanischen Winkelbereichs von 360° genau ni stabile Nullstellen und dadurch eine Mehrdeutigkeit von $\phi$ auftritt; deshalb wird bei absolut arbeitenden Gebern eine Spur mit $n_i = 1$ eingesetzt.

Für jede Meßspur wird eine Spurauswerteelektronik benötigt, die innerhalb der Skalenperiode 360°$/n_i$ die Position mit einer Auflösung von z.B. $a_i$ bit bestimmt. Der Zeitablauf dieser Spurauswertungen wird von einer Steuerlogik (hier Mastertakt genannt) bestimmt, die Meßergebnisse in einer Signalkombinationslogik zu einem Gesamtmeßergebnis kombiniert.

Die Spurauswertung erfolgt in einer Regelschleife, die als eine Art Kapazitätsmeßbrücke ausgebildet ist. Darin wird der "elektrische Winkel" dem mechanischen Winkel ständig nachgeführt. Dieser elektronische Winkel wird in einem Zähler mit $a_i$ bit gespeichert. Daraus werden die oben erwähnten Ansteuerspannun-

gen der Kapazitätsmeßbrücke

$U_1 = U_0 \text{ mod} \times \sin(n_i \times Z_i \times 360° / 2^{a_i})$
$U_2 = U_0 \text{ mod} \times \cos(n_i \times Z_i \times 360° / 2^{a_i})$
$U_3 = U_0 \text{ mod} \times (-\sin(n_i \times Z_i \times 360° / 2^{a_i}))$
$U_4 = U_0 \text{ mod} \times (-\cos(n_i \times Z_i \times 360° / 2^{a_i}))$

mit dessen Zählerstand $Z_i$ abgeleitet. Als Modulationsspannung wird hier eine Rechteckspannung der Frequenz $f_i$ gewählt. Das aus der Spur ausgekoppelte Gegentaktsignal wird auf einen hochohmigen FET-Vorverstärker gegeben, demoduliert und enthält dann die Abweichung des aktuellen mechanischen Winkels vom gespeicherten elektronischen. Diese wird auf einen Regelverstärker mit der gewünschten Regelcharakteristik gegeben. Über einen Fensterkomparator wird nach einer Periode der Modulationsspannung entschieden, ob $Z_i$ inkrementiert, dekrementiert oder unverändert bleiben soll; die maximale Nachregelfrequenz bzw. Bitwechselfrequenz des Ergebnisses beträgt damit $f_i$.

Soll der Meßwert z.B. bei einer maximalen Drehzahl von 6000 U/min entsprechend 100 Hz nachgeführt werden, muß die Modulationsfrequenz mit mindestens

$f_i = n_i \times 2^{a_i} \times 100 \text{ Hz}$

gewählt werden (bei unserer Feinspur ist $n_i = 16$, $a_i = 6$, somit also $f_i$ 102.4 kHz).

Alle Steuersignale der Spurauswertung werden aus einem Frequenzgenerator über einen Zähler und Gatter abgeleitet.

Neben der Modulationsfrequenz für die Kapazitätsbrücke sind dies Demodulatorsignale, Latchsignale zum Abtasten und Halten des Meßergebnisses jeder Meßperiode, sowie Taktsignale zum Inkrementieren und Dekrementieren des elektronischen Winkels. Werden daßei die Modulationsfrequenzen der einzelnen Spuren so gewählt, daß sie um eine Zweierpotenz auseinanderliegen, wird bei Rechteckform ein Übersprechen der Spuren ausgeschlossen.

Bei der Signalkombination werden die niedrigstwertigen Bits des Ergebnisses direkt aus der Feinspur (bzw. der Spur mit dem größeren $n_i$) übernommen. Die höherwertigen Bits werden über eine Verknüpfung der Ergebnisse beider (bzw. bei mehreren Spuren jeweils zweier) Spuren gewonnen. Insbesondere geschieht dies dadurch, daß ein Überlappungsbereich beider Spuren entsteht, d.h. beide Spuren liefern einen Meßwert oder "Bits" für diesen Überlappungsbereich. Idealerweise müssten diese identisch sein, allerdings werden sie sich durch Nullpunktverschiebungen zwischen beiden Spuren, Meßfehler und Regelabweichungen der Grobspur voneinander unterscheiden. Diese Abweichungen werden im Überlappungsbereich erkannt, solange sie unter einem maximal zulässigen Grenzwert bleiben, und die restlichen höherwertigen Bits entsprechend nach unten oder oben korrigiert.

In der konkreten Realisierung werden beide Spuren gezielt in ihrem Nullpunkt so verschoben, daß statt inkrementieren und dekrementieren die höherwertigen Bits nur inkrementiert werden oder unverändert bleiben, was die Schaltung vereinfacht.

Aufgrund des verwendeten Prinzips der Aufteilung der Meßaufgabe in zwei Untersysteme sind zwei Fehlermechanismen zu untersuchen. Der erste mögliche Fehler ist das Versagen der Signalkombination. In diesem Falle würde ein Meßfehler der Grobspur so groß werden, daß der zulässige Signalkombinationsbereich überschritten wird und eine falsche Korrektur des Grobwertes erfolgt. Da dies zu einer sprunghaften Änderung des Meßwertes um ein Vielfaches des niedrigstwertigen Bit führen würde, muß ein solcher Fehler ausgeschlossen werden. Dies ist durch geeignete Aufspaltung der Meßbereiche zu erreichen.

Alle weiteren Fehler betreffen Ungenauigkeiten in der Größenordnung der Meßauflösung. Hier sind aufgrund des verwendeten Prinzips nur Fehler bei der Feinspur (bzw. bei mehr als zwei Spuren die höchstauflösende) zu berücksichtigen. Sie wird deshalb die Spur mit dem größten Radius sein.

Allerdings ist das Prinzip des Gebers mit einigen selbstkorrigierenden Eigenschaften versehen: Gerade bei hochgenauen optischen Gebern ist **Exzentrizität** oder Codescheibe sehr kritisch. Da nur an einem Punkt der Skala abgelesen wird, verursacht eine Exzentrizität dE einen Meßfehler von maximal

$$d\theta = \frac{dE}{r}$$

Beim vorgeschlagenen Prinzip wird jedoch über den gesamten Umfang der Skala gleichzeitig gemessen, wobei an verschiedenen Punkten (Beläge) die Exzentrizität mit unterschiedlichen Vorzeichen wirkt und deshalb der Einfluß der Exzentrizität nahezu vollständig verschwindet.

Skalen- oder Teilungsfehler, verursacht durch Fehler der Vorlage, Ätzfehler, etc. werden durch Verwendung einer Vielzahl von Meßorten statistisch reduziert. Da gerade die Feinspur eine hohe Zahl von Meßorten besitzt und diese für die Endgenauigkeit verantwortlich ist, kann diese statistische Reduzierung besonders gut zur Geltung kommen.

Auch gegen die Verkippung des Rotors oder eines Stators ist das Verfahren relativ unempfindlich. Da nämlich die Meßsignale von dem einen Stator auf die einzelnen isolierten Beläge des Rotors gekoppelt und erst im anderen Stator wieder zusammengeführt werden, kann man von einer Vielzahl individueller Meßflächen sprechen. Bewegt sich an einem Ort der Rotor auf den einen Stator zu, wird g1eichzeitig die Entfernung zum anderen Stator größer, wobei die Signalkopplung und damit der Beitrag dieser Meßfläche zur Gesamtmeßfläche nahezu konstant bleibt. Verschiebung eines Stators dagegen verändert zwar einen Luftspalt, jedoch bleibt der andere konstant, so daß der Gesamteffekt reduziert wird.

Die Genauigkeit der Interpolation wird durch die erzeugten Kurvenform und Nullpunktverschiebungen der Sinus- und Cosinusnetzwerke beeinflußt. Diese Anforderungen sind aber im Vergleich zu Resolverausweschaltungen um die Polpaarzahl $n_i$ der feinsten Spur geringer.

Durch Verwendung von Gegentaktansteuerung werden einerseits Streukapazitäten, sowie sie ausbalanciert (gleich groß gemacht) werden, und andererseits elektrische Einstreuungen unterdrückt.

Zudem lässt sich die Modulationsfrequenz so wählen, daß der Geber gegen bekannte Störspektren weitgehend unempfindlich wird.

Durch die selbstabgleichende Meßbrücke sind auch schwankende Verstärkungsfaktoren ohne Einfluß, da sich nur die Abgleichempfindlichkeit ändert und bei geeigneter Regelcharakteristik auch diese unkritisch wird (I-Verhalten).

Sollte trotzdem ein kurzfristiger Meßfehler auftreten, so wird er durch nachfolgende Messungen wieder korrigiert, da es sich um ein absolut messendes System handelt.

Absolutwinkelgeber werden häufig in Positioniersteuerungen eingesetzt. Zur Verbesserung des dynamischen Verhaltens solcher Regelkreise wird gelegentlich neben der Position auch die Bewegungsgeschwindigkeit erfasst.

In solchen Fällen war bisher oft ein zweites Geberbauteil, nämlich ein Tachogeber, erforderlich. Die Geschwindigkeitsinformation kann aber auch durch Differentiation aus dem Positionssignal abgeleitet werden. Der hier vorgeschlagene Geber kann ein solches Geschwindigkeitssignal liefern: Dazu wird das den elektronischen Zähler ansteuernde Taktsignal auf einen geeigneten Frequenz-Spannungswandler gegeben. Dreht der Geber mit maximaler Drehzahl in eine Richtung, wird in jedem Meßintervall ein Zählsignal abgegeben und maximale Spannung ausgegeben; bei entgegengesetzter Richtung wird über die Auswertung der Richtungsinformation die Polarität der Ausgangsspannung umgekehrt; insgesamt ergibt sich ein linearer Verlauf U (v) mit U = o für v = o.

Im Vergleich zu optischen oder induktiven Gebern sind die dem Ausgangssignal überlagerten Reste der demodulierten Modulationsfrequenz leichter auszufiltern und die Dynamik infolge der hohen Bandbreite des Meßsystems besser.

Im folgenden wird die Erfindung anhand von lediglich einen Ausführungsweg darstellenden Zeichnungen näher erläutert.

Es zeigen:

Bild 1: Schnitt durch einen Drehgeber nach der Erfindung mit übertriebener Darstellung einer Verkippung des Rotors,

Bild 2: Blockschaltbild der elektrischen Schaltung,

Bild 3: ein gegenüber Bild 2 detailliertes Blockschaltbild der Auswerteschaltung,

Bild 4: perspektivische Vorderansicht des Drehgebers,

Bild 5: perspektivische Rückansicht des Drehgebers in auseinandergezogener Darstellung,

Bild 6: einen Ausschnitt aus dem einen Stator,

Bild 7: einen Ausschnitt aus dem Rotor,

Bild 8a: schematisiert die Anordnung der Belagabschnitte im Bereich der Feinspur,

Bild 8b: die Darstellung des sinusförmigen Verlaufes entstehend aus der Integration über die Beläge,

Bild 8c: schematisiert ein Differenzbildner,

Bild 8d: die Formel zur Berechnung des elektrischen Winkels und des mechanischen Winkels,

Bild 9: ein gegenüber Bild 2 abgewandeltes Ausführungsbeispiel der Auswerteschaltung,

Bild 10: schematisiert die Winkelangabe der Grobspur,

Bild 11: schematisiert die Signalkombination aus den Signale der Grobspur und der Feinspur,

Bild 12: schematisiert die Winkelangabe der Feinspur,

Bild 13: ein Funktionsbild, wie in der Kombinationslogik das digitale Ausgangssignal gewonnen wird,

Bild 14: die bitweise Darstellung der Gewinnung des digitalen Ausgangssignal,

Bild 15: die schematisierte Darstellung der Sinusform der Elektroden auf dem Rotor .

Im Luftspalt zwischen dem Stator 1 und dem Stator 2 ist ein Rotor drehbar angeordnet, der über nicht näher dargestellte Drehlager am Gehäuse drehbar gelagert ist und der ferner drehfest mit einer Welle 4 verbunden ist, die nach außen außerhalb des Gehäuses geführt ist und dort drehfest mit dem Meßobjekt gekoppelt ist.

Im vorliegenden Ausführungsbeispiel sind Stator 1,2 und Rotor 3 kreisscheibenförmig ausgebildet . Der Außenumfang von Stator und Rotor ist jedoch hierbei gleichgültig. Wesentlich nach der vorliegenden Erfindung ist nur, daß die später zu beschreibenden Beläge kreisringförmig auf den genannten Teilen 1,2,3 angeordnet sind.

In einer anderen Ausführungsform der vorliegenden Erfindung es vorgesehen, daß der Drehgeber als Linear-Geber ausgebildet ist. Hierbei ist dann der Rotor 3 als axial verschiebbares Linear in einem Gehäuse geführt und ist mit seinem einen freien Ende mit dem Meßobjekt gekoppelt, welches ebenfalls linear verschiebbar ist.

Zur weiteren Erläuterung des Bildes 1 wird dargelegt, daß die Dicke des Rotors "a" beträgt und der Buchstabe d für den Luftspalt zwischen den beiden einander gegenüberliegenden Statoren steht abzüglich der Dicke a des Rotors.

Die später noch zu beschreibende elektronische Auswerteschaltung könnte beispielsweise auf der rechten Seite des Stators 2 im Gehäuse angeordnet werden und durch einen nicht näher dargestellten Gehäusedeckel abgedeckt werden.

Entsprechend den klimatischen Anforderungen am Meßort kann das Gehäuse auch hermetisch gekapselt sein.

In der Zeichnung, Bild 1, ist ferner noch dargestellt, daß der Rotor einen gewissen Verkippungs- oder Verkantungsfehler aufweisen kann; dieser Verkantungsfehler ist in Bild 1 absichtlich übertrieben dargestellt, um zu zeigen, daß auch bei derartig großen Verkantungsfehlern ein einwandfreies Meßergebnis gewährleistet ist.

Es ist nämlich erkennbar, daß in der gezeichneten Stellung im Bild 1 der Rotor 3 in Bezug zum Luftspalt zum Stator 1 die Luftspaltlänge $^d/2$ + Delta, während der Rotor mit seiner gegenüberliegenden Seite zum Luftspalt des Stators 2 die reduzierte Luftspaltlänge $^d/2$ - Delta aufweist.

Das Meßprinzip des Funktionsbildes nach Bild 1 beruht nun darauf, daß zwischen dem Stator 1 und dem Rotor 3 der eine Luftspalt, z.B. der Luftspalt 5, als Meßluftspalt ausgebildet ist, während der zweite Luftspalt 6 zwischen dem Rotor 3 und dem Stator 2 als Auskoppelluftspalt ausgebildet ist. Die Definition dieser beiden Begriffe "Meßluftspalt" und "Auskoppelluftspalt" wird später gegeben.

Das Meßprinzip bei dem Funktionsschaltbild nach Bild 1 besteht nun darin, daß zwischen dem Stator 1 und dem Rotor 3 im Bereich des Meßluftspaltes die Leiterbahnmuster (Beläge) auf den sich gegenseitig zugewandten und durch den Luftspalt 5 voneinander getrennten Seiten von Stator 1 und Rotor 3 Kondensator-Beläge eines Kondensator-Netzwerkes sind, dessen Kapazitätswerte vom Drehwinkel abhängen (Meß-Kondensator-Anordnung).

Die Leiterbahnmuster (Beläge) auf den sich gegenseitig zugewandten Seiten von Rotor 3 und Stator 2 bilden Kondensatoren, deren Kapazitäten vom Drehwinkel idealerweise völlig unabhängig sind; deshalb erfüllen diese nur eine Auskoppelfunktion und der Luftspalt 6 dazwischen wird deshalb als Auskoppelluftspalt bezeichnet.

In dem Ausführungsbeispiel nach Bild 2 , welches nur als Beispiel zu verstehen ist, weist der Rotor 3 auf der einen Seite eine Belag-Struktur 13 auf, während auf der gegenüberliegenden Seite eine Belag-Struktur 14 angeordnet ist.

Über später noch zu beschreibende elektrische Kontaktierungen sind die Belag-Strukturen 13 und 14 miteinander verbunden.

Getrennt durch den Luftspalt 5 sind der Belagstruktur 13 gegenüberliegend Belagabschnitte 7 - 10 auf dem Stator 1 angeordnet, wobei diese Belagabschnitte 7 - 10 elektrisch voneinander getrennt sind.

Jedem Belagabschnitt 7 - 10 ist eine Leitung 7a- 10a zugeordnet, die den Ausgang eines Oszillators 15 bildet, an dessen Eingang über die Leitung 16 ein Steuersignal eingekoppelt wird, welches als Ausgangssignal einen Regler 17 verlässt. Der Eingang des Reglers wird hierbei durch Leitungen 11a, 12a gebildet, die ihrerseits wiederum leitfähig mit Belagabschnitten 11,12 des Stators 2 verbunden sind.

Der Stator 2 ist über den Luftspalt 6 (Auskoppelluftspalt) mit der gegenüberliegenden Seite, nämlich mit der Belagstruktur 14 des Rotors 3 kapazitiv gekoppelt.

Bei dem Oszillator 15 handelt es sich um einen freilaufenden Oszillator, insbesondere um einen Zähler, der entweder herauf- oder herunterzählt, wobei entsprechend dem am Eingang des Oszillators 15 anliegenden Steuersignal der Zähler angehalten wird und dann an seinem Ausgang über die zwei parallel zueinander liegenden digitalen Meßwerte, welche auf einen analogen Ausgang wirken, eine Sinus-,Kosinus-,

8

Minus-Sinus-und Minus-Kosinus-Amplitude erzeugen, die jeweils mit einer bestimmten Meßfrequenz moduliert wird, so daß dieses modulierte Signal über die Luftspalte 5,6 übertragen werden kann.

Eine nähere Erläuterung dieses Prinzips erfolgt dann in Verbindung mit dem Bild 4.

Der Regler 17 bzw. der Empfänger demoduliert das von den Belagabschnitten 11,12 empfangene Meßsignal über seine den Eingang bildenden Leitungen 11a und 12a und bildet daraus ein Steuersignal, welches über die Leitung 16 auf den Eingang des Oszillators 15 einwirkt.

Das Bild 3 zeigt im einzelnen die Gesamtschaltung im Blockschaltbild.

Das Blockschaltbild nach Bild 3 enthält zwei im wesentlichen identische Blöcke 18 und 19, die gleich aufgebaut sind, jedoch mit verschiedener Frequenz arbeiten. Der Einfachheit halber wird daher nur die Funktion eines der Blöcke 18 oder 19 beschrieben, während der andere Block in analoger Weise funktioniert.

Der Einfachheit halber wird ferner im folgenden die Funktion des Blockes 19 in Bezug auf das Grobsystem beschrieben, wobei der Block 18 in Bezug auf das Feinmeßsystem in analoger Weise arbeitet.

Der Oszillator 15 gemäss Bild 2 besteht im wesentlichen aus einem Zähler 20, dessen Ausgänge 21 beispielsweise als Sechsdrahtleitung einer Kombinations-Logik zugeführt werden, die auf eine 10-Bit-datenparallele Ausgabe einwirkt und diese steuert.

Entsprechend dem Bit-Zustand der Ausgänge 21 werden an den Leitungen 22,23 Signale geformt, die einem Block 24,25 zugeführt werden, der jeweils aus dem auf der Leitung 22,23 anliegenden Signal ein Sinus-Signal bzw. Kosinus-Signal formt.

Wenn also beispielsweise binär von dem Zähler 20 auf den Ausgängen 21 ein Winkel von beispielsweise 0 Grad anliegt, dann ist ein bestimmter Zustand erreicht, der in dem Bild 2 mit dem Begriff "Zustand" gekennzeichnet ist, und entsprechend diesem Winkel werden dann die Kurvenformen gemäss Bild 2 auf den Leitungen 7a - 10a erzeugt.

Auf Leitung 7a und 9a liegt dann eine Wechselspannung mit der Amplitude 0; auf den Leitungen 8a und 10a erscheint dann die maximal mögliche Amplitude; die Signale dieser beiden Leitungen sind zueinander komplementär.

Am Ausgang 26 des Blockes 24 erscheint also ein Sinus-Signal, während am Ausgang 27 des Blockes 25 ein Kosinus-Signal erzeugt wird. Beide Ausgänge 26,27 sind auf jeweils einen Multiplexer 28,29 geschaltet und jeweils ein Multiplexer 28,29 weist jeweils zwei Ausgangsleitungen 30,31 auf, die auf Treiber wirken, wobei jeder Treiber über die zugeordnete Leitung 7a - 10a auf den zugeordneten Belagabschnitt 7-10 wirkt.

Diese Signale werden dann von den Belagabschnitten kapazitiv durch den Luftspalt 5 auf die Belagstruktur 13 des Rotors 3 übertragen, währenddessen am Auskoppelluftspalt 6 die Belagstruktur 14 den Belagabschnitten 11,12 gegenüberliegt und eine kapazitive Einkopplung auf die Belagabschnitte 11,12 erfolgt, wobei ein Differenzverstärker in dem Demultiplexer 33 nachgeschalteten Block 34 angeordnet ist, der aus den beiden im Gegentakt zueinander befindlichen Meßsignalen ein einziges Meßsignal formt, welches als Fehlersignal einem Regler zugeführt wird.

Wenn das Fehlersignal unterhalb einer bestimmten Schwelle bleibt, werden die nachgeschalteten Blöcke 35,36 so gesteuert, daß der Zähler 20 seinen aktuellen Zählerstand beibehält; überschreitet der Reglerausgang eine bestimmte obere Schwelle, dann werden entsprechend dem Signal die Blöcke 35,36 so beeinflusst, daß der Zähler 20 um einen Schritt nach oben zählt. Wenn der Reglerausgang einen unteren Grenzwert überschreitet, wird bewirkt, daß der Zähler 20 einen Schritt nach unten zählt.

Die beiden vom Ausgang des Demultiplexers 33 kommenden Fehlersignale werden im Subtrahierer (Block 34) voneinander abgezogen, so daß sich im Idealfall ein Nullsignal bildet, welches den Regler nicht beeinflusst. Der Regler ist damit stabil und erzeugt keine Veränderung des Zählers 20 über die Eingänge 37,38. Kommt es aber zu einer Abweichung zwischen den beiden Ausgängen des Demultiplexers 33, dann ist das vom Subtrahierer 34 gebildete Signal nicht mehr Null und wirkt in der oben beschriebenen Weise auf den Regler ein.

Hierbei wird der Takt der gesamten Schaltung über den Oszillator 41 erreicht. Auf dem Eingang 40 der Steuerung 39 liegt ein höherwertiges Bit des Zählers 20 an, z.B. das MSB:

Die Steuerung 39 erhält über die Leitung 42 zunächst den Mastertakt von dem Oszillator 41. Die Zuführung des höherwertigen Bits auf der Leitung 40 dient dazu, in der beschriebenen Weise die Signale Sinus, Kosinus, Minus-Sinus und Minus-Kosinus zu erzeugen.

Hierbei ist erkennbar, daß im Block 24 ein dreieckförmiges positives Signal erzeugt wird, welches von den nachgeschalteten Bausteinen (Multiplexer, Treiber) zu einem Sinus-Signal geformt wird, während bei dem Block 25 ein Kosinus-Signal durch die nachfolgenden Bausteine geformt wird.

Diese Kurvenformen werden unabhängig von der Art und dem Betrag des Fehlersignals erzeugt.

In einer Weiterbildung der vorliegenden Erfindung ist es vorgesehen, daß von dem Block 34, in dem der Subtrahierer und Regler enthalten ist, über die Leitung 43 ein Geschwindigkeitssignal über den f-u-Wandler 44 ausgekoppelt wird. Dieses Geschwindigkeitssignal dient dazu, die Umdrehungsgeschwindigkeit des Meßobjektes als zusätzliche Information zu gewinnen.

Aus den jeweilig 6-Bit breiten Ausgängen der Zähler 20 und 20a wird in der Kombinations-Logik 45 ein binäres Ausgangssignal erzeugt, welches auf eine 10-bit breite Parallelausgabe 46 gegeben wird, an deren Ausgang der analoge Drehwinkel als 10-Bit-Signal erfassbar und weiterverarbeitbar ist.

In der Kombinations-Logik werden die Signale des Feinmeßsystems entsprechend dem Block 18 und die Signale des Grob-Meßsystems entsprechend dem Block 19 zusammengefasst und hierbei werden 2 Bit entfernt, um eine fehlerfreie Überlagerung beider Signalsysteme zu erreichen. Eine weitere Erläuterung der Funktion erfolgt anhand der Bilder 13 und 14.

Die Bilder 4 und 5 zeigen im einzelnen ein praktisches Ausführungsbeispiel eines Drehwinkelgebers nach der vorliegenden Erfindung, wobei das Bild 4 die Vorderansicht des Drehwinkelgebers und das Bild 5 die Rückansicht des Drehwinkelgebers darstellen.

Auf der Vorderseite des Stators 1 sind vier spiralförmige Leiterbahnen 47-50 angeordnet, wobei die Leiterbahnanfänge bzw. -Einkopplungen etwa gleichmässig am Umfang verteilt angeordnet sind und die einzelnen Leiterbahnen 47-50 spiralförmig ineinander so gewunden sind, daß sie genau einen gleichmässigen Abstand voneinander aufweisen und sich nicht berühren.

Sie dienen dazu, die auf der Rückseite des Stators 1 (vergl. Bild 5) angeordneten Belagabschnitte 7 - 10 über noch später darzustellende Durchkontaktierungen miteinander zu verbinden, d.h. also, alle Belagabschnitte mit dem Bezugszeichen 7 werden durch eine spiralförmige Leiterbahn, z.B. der Leiterbahn 47 verbunden, während die anderen Belagabschnitte entsprechend verbunden werden. Die Belagabschnitte 7 - 10 sind hierbei Teil der als Belag 55 definierten Struktur.

Durch die innere Ausnehmung 51 des Stators 1 greift die Welle 4 hindurch, die in der vorher beschriebenen Weise drehfest mit dem Rotor 3 verbunden ist.

Auf der in Bild 4 gezeigten Seite des Rotors 3 sind am Außenumfang in gegenseitigem Abstand verteilt und parallel zueinander einzelne Beläge 52 in Form von länglichen leitfähigen Streifen angeordnet, die Teil des Feinmeßsystems sind, während die im Innenraum des Rotors 3 angeordneten Beläge 53 Teil des Grobmeßsystems sind.

Die Art, d.h . also die Anordnung und die Formgebung der Beläge 52,53, ist in der Beschreibungseinleitung in den dort beschriebenen mathematischen Funktionen definiert.

Sie sind so geformt, daß die Überlappungsflächen einander gegenüberliegender Beläge, z.B. der Beläge 52 auf dem Rotor 3 zu den Belägen 55 mit den Belagabschnitten 7 - 10 auf dem Stator 1 sich bei Verdrehung stückweise sinusförmig ändern. Bei der Formgebung gibt es unendlich viele Möglichkeiten. Die in der praktischen Ausführung gewählte Formgebung beruht darauf, daß die Belagabschnitte 7 - 10 des Belages 55 des Stators 1 innerhalb eines festzulegenden Winkelbereichs eine konstante Belegungsdichte aufweisen, während beispielsweise die Beläge 52 des Rotors 3 eine Belegungsdichte entsprechend einer Sinus-Funktion aufweisen.

Auf der in Bild 4 sichtbaren Seite des Stators 2 sind konzentrische leitfähige Kreisringbahnen gezeigt, wobei insgesamt vorzugsweise vier Stück vorhanden sind, welche Teil des Auskoppelluftspaltes 6 sind.

Gemäss Bild 5 sind auf der Innenseite des Stators 1 die der Feinspur zugeordneten Beläge 55 kreisringförmig am Außenumfang des Stators 1 angeordnet, während die der Grobspur zugeordneten Beläge 56 zirkular gleichmässig verteilt am Innenumfang des Stators 1 angeordnet sind.

Die Formgebung der Beläge 55 entspricht der vorher gegebenen Definition (konstante Belegungsdichte), wobei in einem bevorzugten Ausführungsbeispiel 4 mal 16 Beläge 55 vorhanden sind, welche die Feinspur bilden, und vier Beläge 56, welche die Grobspur bilden.

Auf der Rückseite des Rotors 3 sind im Bereich der Feinspur 2 radial zueinander versetzte Beläge 57,58 in Form von Kreisringausschnitten angeordnet. Hierbei ist wesentlich, daß die radiale Länge der auf der Vorderseite des Rotors angeordneten Beläge 52 sich mit der radialen Länge der beiden Beläge 57,58 deckt, so daß jeweils zwei benachbarte Beläge 52 auf der Vorderseite des Rotors als gegensätzlich gepolt betrachtet werden können und jedem gleichpolig gepolten Belag 52 ist dann entweder der Belag 58 oder der Belag 57 zugeordnet. Jedes gleichpolige Element des Belages 52 ist beispielsweise mit einem Element des Belages 58 verbunden, während jedes anderspolige Element des Belages 52 (dies ist jedes zweite Elemente des Belages 52) mit jeweils einem Element des Belages 57 verbunden ist.

Den Belägen 53, welche die Grobspur auf der Vorderseite des Rotors 3 bilden, (vergl. Bild 4), sind die kreisringförmigen Beläge 59 auf der Rückseite des Rotors 3 zugeordnet.

Die im Bild 4 gezeigten Kreisringbahnen 54 auf der einen Seite des Stators 2 sind auf der Rückseite gemäss Bild 5 jeweils mit Kontaktbahnen 60 verbunden, die über entsprechende Kontakte mit der Auswertelektronik verbunden sind.

Jeweils zwei Leitungen der Kontaktbahnen 60 bilden die Leitungen 11,12 des Grobmeßsystems bzw. die Leitungen 11a, 12a des Feinmeßsystems.

Das Bild 6 zeigt einen kreisringsektorförmigen Ausschnitt aus dem Stator 1 und zwar mit Darstellung der auf der Vorder- und Rückseite angeordneten Beläge 55 mit den Belagabschnitten 7 - 10 bzw. den Leiterbahnen 47 - 50, welche bestimmte Belagabschnitte miteinander verbinden.

Hierbei sind Durchkontaktierungen 61 in geeigneter Weise so gelegt, daß beispielsweise die Leiterbahn 47 über entsprechende Durchkontaktierungen 61 mit dem Belagabschnitt 7 verbunden ist, während die Leiterbahn 48 mit dem Belagabschnitt 8 und die Leiterbahn 49 mit dem Belagabschnitt 9 und die Leiterbahn 50 mit dem Belagabschnitt 10 verbunden ist.

Auf der radial innenliegenden Seite des kreisringsektorförmigen Ausschnittes beim Stator 1 ist sichtbar, daß der der Grobspur zugeordnete Belag 56 ebenfalls kreisringsektorförmige Formgebung aufweist und über eine Durchkontaktierung 61 mit einem Kontakt verbunden ist, so daß er mit einem entsprechenden Draht kontaktiert werden kann.

Das Bild 7 zeigt in analoger Weise einen Ausschnitt aus dem Rotor 3, wo erkennbar ist, daß die der Feinspur zugeordneten Beläge 58 und 57, die beide gestrichelt dargestellt sind, über entsprechende Durchkontaktierungen 61 mit den auf der anderen Seite angeordneten Belägen 52 jeweils verbunden sind, in der Weise, wie es vorhin beschrieben wurde.

Ebenso ist erkennbar, daß die sichelförmigen Beläge 53, welche der Grobspur des Rotors 3 zugeordnet sind, über entsprechende Durchkontaktierungen mit den kreisringförmigen Belägen 59 auf der anderen Seite des Rotors verbunden sind.

In Bild 8a ist die Abwicklung in der Ebene der Beläge 56 des Stators 1 dargestellt, wobei die Darstellung in Bild 8 a und b sowohl für die Abwicklung der Grobspur als auch für die Abwicklung der Feinspurbeläge zutreffend ist. Daher wurden auch die Belagabschnitte 7 - 10 der Beläge 55 der Feinspur des Stators 1 eingezeichnet. Der Einfachheit halber werden im folgenden nur die Funktionen der Grobspurbeläge 56 dargestellt; in analoger Weise gilt dann die Erläuterung auch für die der Feinspur zugeordneten Beläge 55.

Bild 8b zeigt die lineare Abwicklung der sichelförmigen Beläge 53 der Grobspur des Rotors 3. Das Bild 8c zeigt in einem Funktionsschaltbild, wie aus den beiden Flächenelementen E1 und E2 eine Differenz gebildet wird, welche zu dem Signal S führt, das am Ausgang des Differenzbildners erscheint. Das Bild 8d zeigt die Formel für das Fehlersignal, welches aus dem elektrischen und dem mechanischen Winkel gebildet wird.

In Bild 8a ist der Abstand zwischen den rechteckförmigen Belagabschnitten 7 - 10 der Beläge 56 der Einfachheit halber nicht dargestellt.

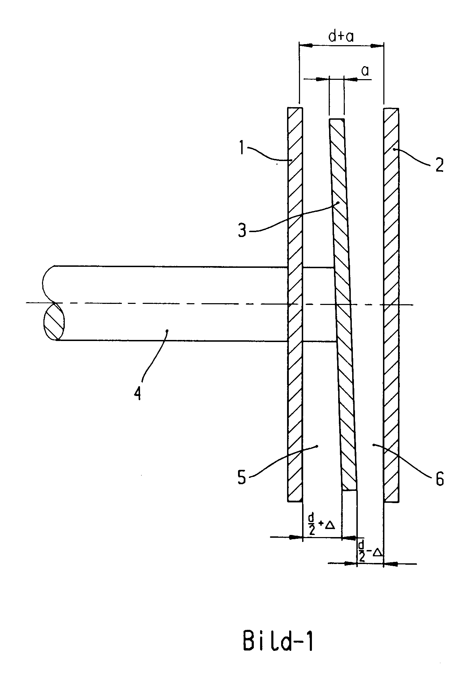

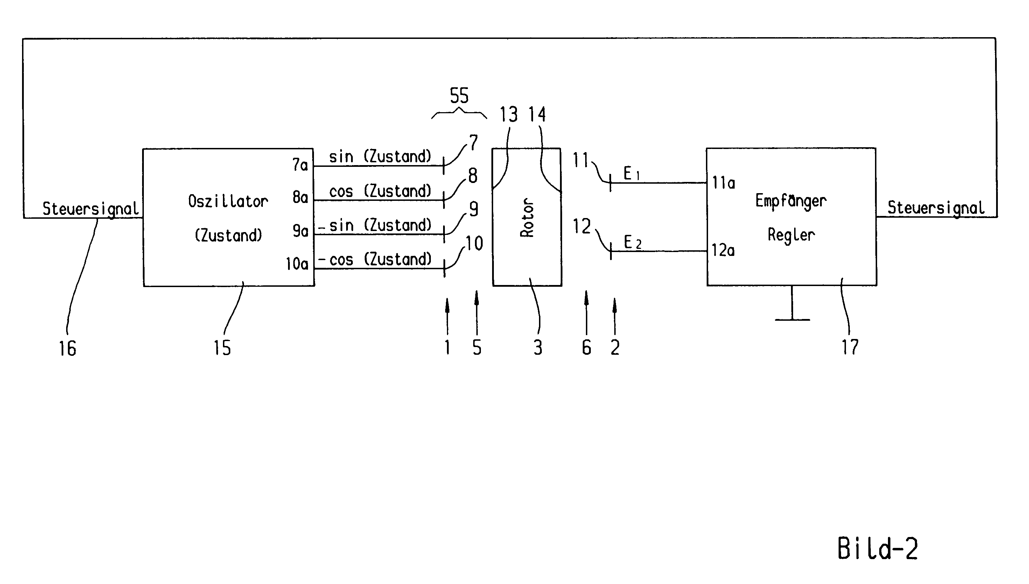

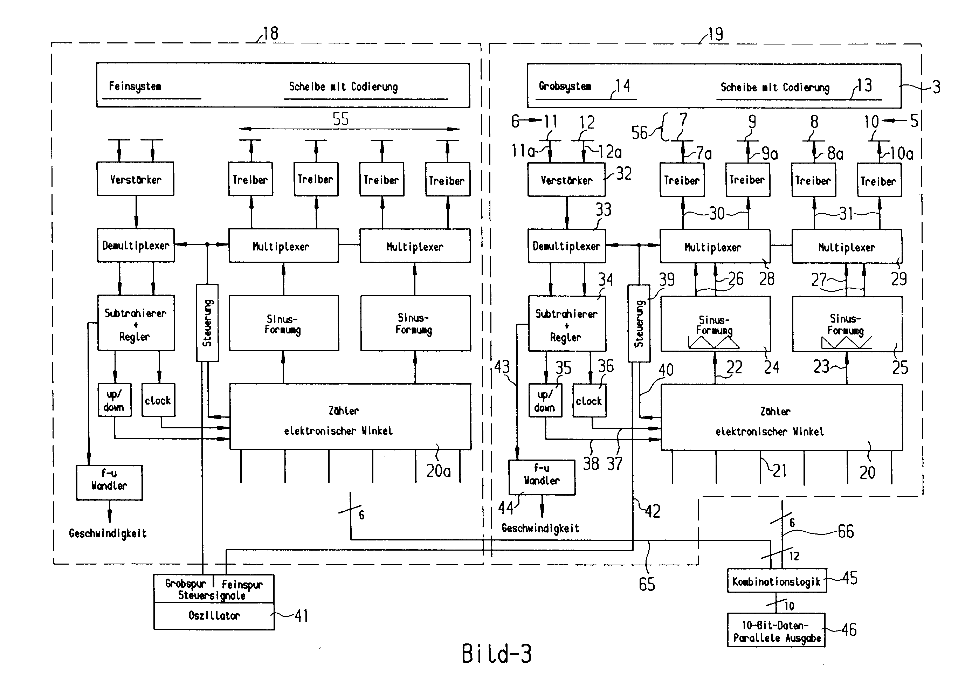

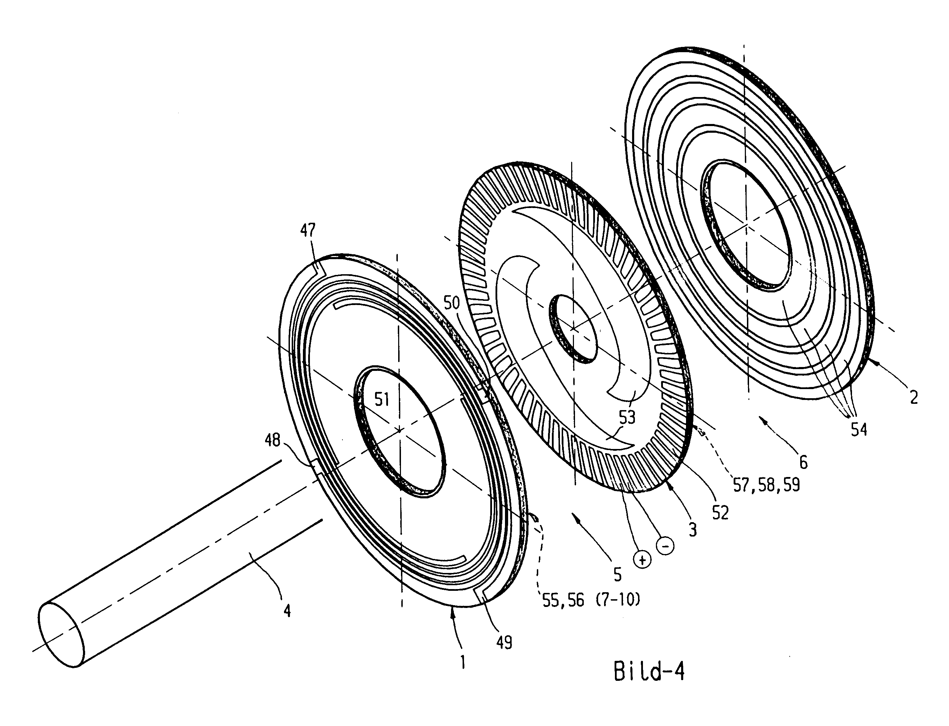

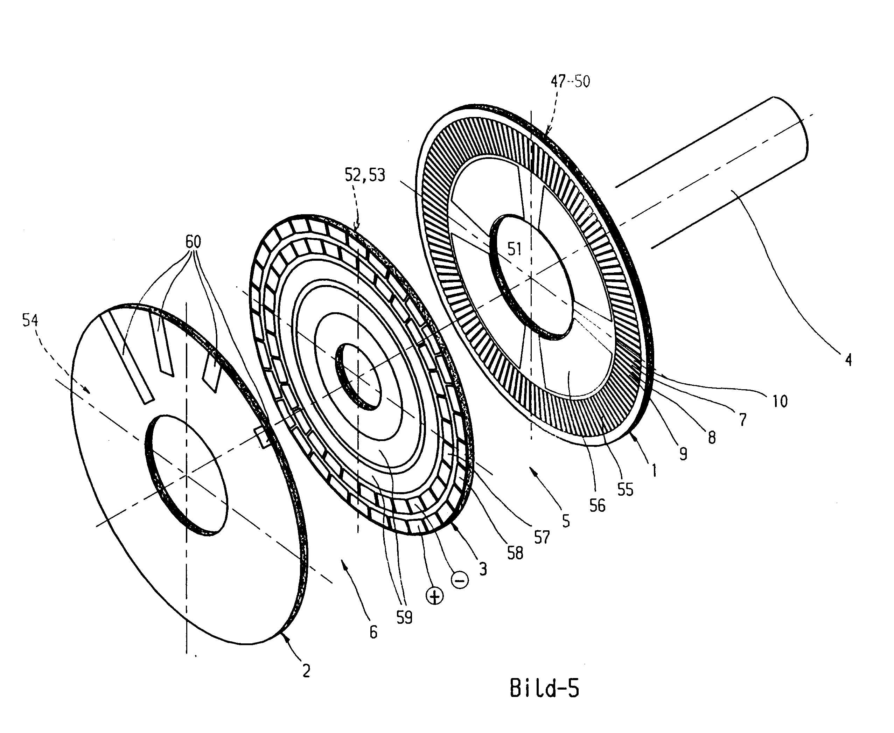

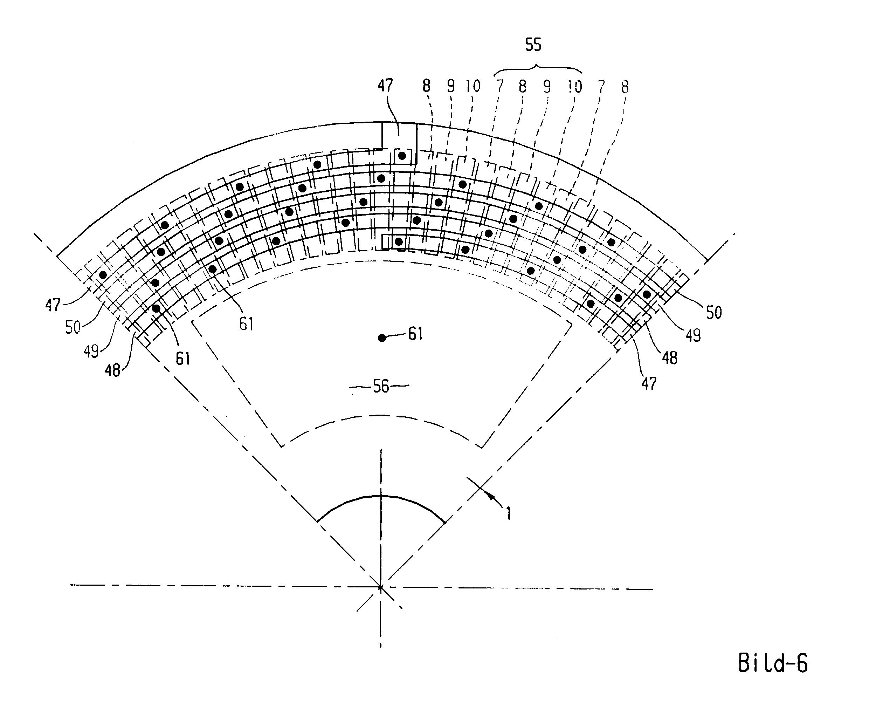

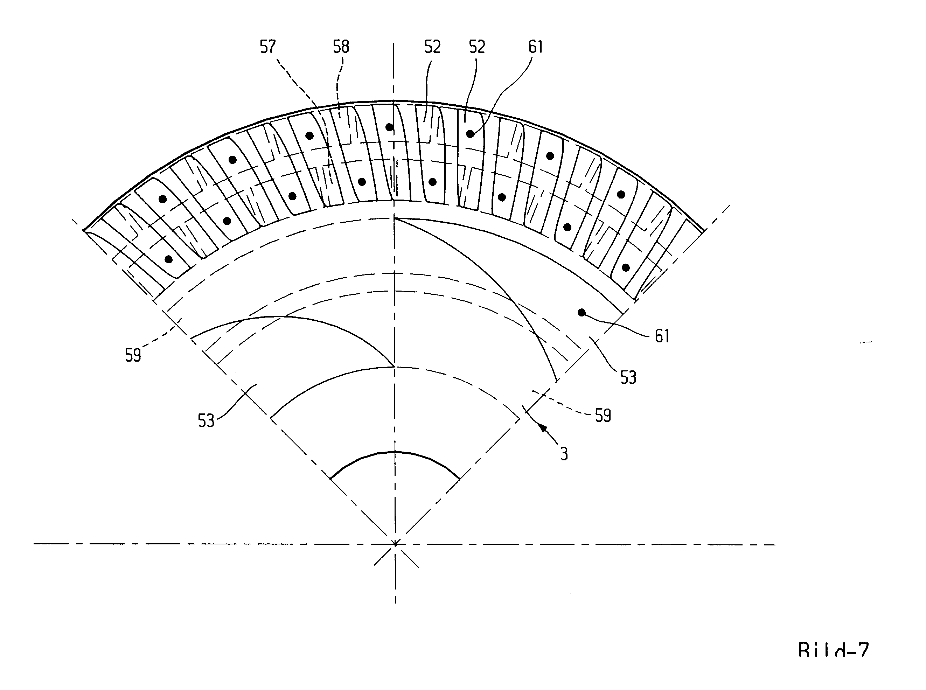

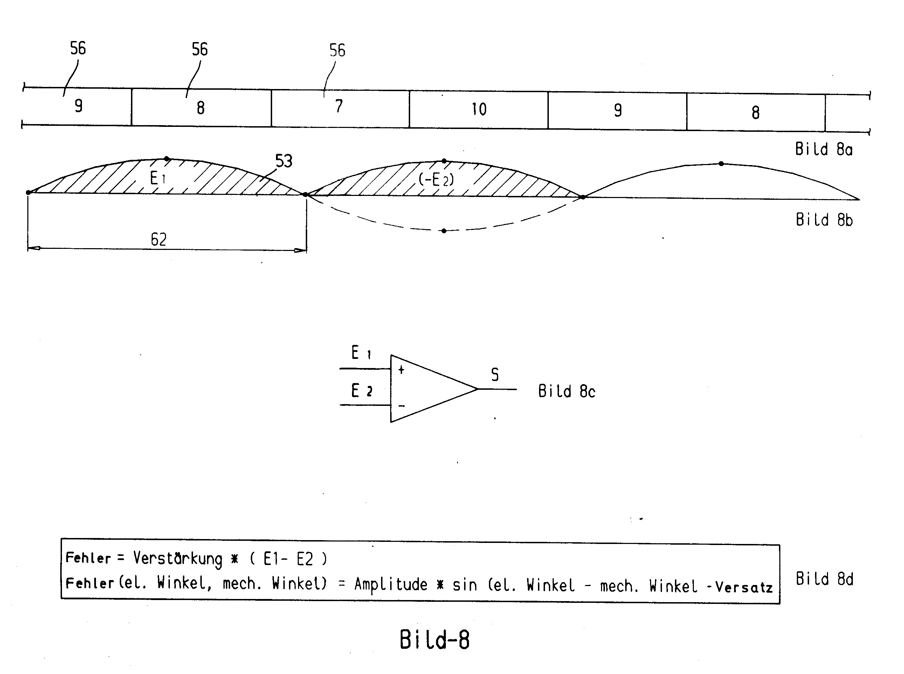

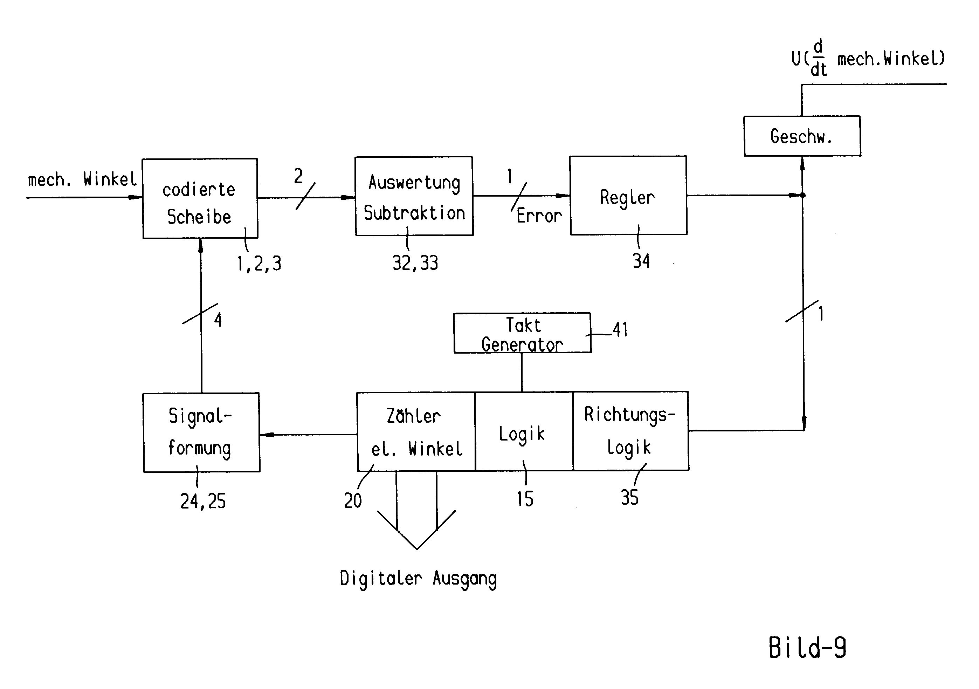

Die schraffierte Fläche in Bild 8b ist die Fläche entsprechend der Meßgröße. Im gezeichneten Ausführungsbeispiel bilden die Beläge 53,56 der Figuren 8a und 8b eine beliebige Gegenüberstellung.

Wenn man nun die Auswerteschaltung so wählt, daß der Belag Minus E2, der in Bild 8b obenliegend gestrichelt dargestellt wird, umgekehrt gepolt wird, dann wird dieser Belag nach unten verklappt und damit wird die gestrichelt gezeichnete Kurve eines idealen Sinus erreicht.

Nachdem also hier ein stückweiser Sinus gebildet wird, erreicht man durch die Hintereinanderschaltung dieser Beläge einen vollständig durchgehenden (stetigen) Sinusverlauf.

Das Signal E1 ist beispielsweise die flächengleiche Aufsummierung der Signale der Beläge 9,8,7 im Bereich 62, so daß sich aus dieser Integration über die Signale der Beläge die Spannung E1 ergibt, aus der dann entsprechend der oberen Formel in Bild 8d das H Fehler-Signal gebildet wird, welches dann entsprechend der obigen Darlegung sowohl vom elektrischen Winkel als auch vom mechanischen Winkel abhängig ist.

Der Versatz nach Bild 8d gibt eine erste Beziehungsgröße an, die während der Messung nicht geändert wird, die sich auf die Befestigung des Gehäuses, der Achse sowie dem Komponenten-Inhalt des Gehäuses bezieht.

Das Bild 9 zeigt das System noch einmal als Regelkreis entsprechend der Schaltung, wie sie anhand des Bildes 3 dargestellt wurde, wobei ein vereinfachtes Blockschaltbild dargestellt ist, wobei die in Bild 3 erläuterten Teile in Bild 9 enthalten sind und daher für diese Teile die gleiche Erläuterung wie für Bild 3 gilt.

Man sieht hieraus, daß es sich um ein geschlossenes Regelsystem handelt, das nach dem Einschalten gegen den tatsächlichen Meßwert konvergiert und im Verlaufe der Messung diesem folgt.

Die Bilder 10 bis 12 zeigen in schematisierter Form, wie die Signale der Grobspur mit den Signalen der Feinspur kombiniert werden, so daß ein Signal hoher Auflösung mit Absolut-Funktion erreicht wird.

In Bild 10 wird gezeigt, wie der Zeiger 63 der Grobspur den Winkel absolut - aber mit geringer Genauigkeit und Auflösung angibt. In Bild 12 wird vom anderen System mit hoher Auflösung aber mit einer Vieldeutigkeit ein weiterer Meßwert für den Winkel gegeben. In Bild 11 wird aus den Meßwerten bzw. den Zeigern in Bild 10 und 12 ermittelt, welcher Winkel tatsächlich aufgetreten ist. So wird einerseits die Ungenauigkeit aus Bild 10 und die Mehrdeutigkeit aus Bild 12 herausgenommen und es entsteht eine Winkelmessung mit den Vorteilen von Bild 10 , nämlich der absoluten Funktion und dem Vorteil von Bild 12, nämlich der Genauigkeit , ohne deren jeweiligen Nachteile.

In Bild 13 ist die Zusammenführung der Signale der Grobspur und der Feinspur gezeigt, wobei als Verallgemeinerung gezeigt ist, daß noch weitere Signale zugeführt werden können, wie z.B. von einer mittelauflösenden Spur oder von anderen Spuren.

Hier ist erkennbar, daß der von der Leitung 65 in Bild 3 kommende 6 Bit breite Ausgang der Feinspur mit der Leitung 66, welche ebenfalls 6 Bit breit ist, von der Grobspur zusammengeführt wird und beide Signale werden in der Kombinationslogik 45 zusammengefasst und als 10-Bit-breiter Datenausgang einer digitalen Auswertung zugeführt.

Die Kombination dieser beiden 6 Bit breiten Leitungen in der Kombinationslogik 45 erfolgt wie folgt:

Die 6 Bit der Feinspur werden direkt als die 6 niedrigwertigsten Bits in das digitale Ausgangssignal übernommen. Die vier höchstwertigen Bits der Grobspur werden in Abhängigkeit von einer noch näher zu beschreibenden Verknüpfung entweder um eins erniedrigt, erhöht oder unverändert gelassen und bilden die oberen, höherwertigen vier Bits des digitalen Ausgangssignals. Die beiden höchstwertigen Bits der Feinspur und die beiden niedrigwertigsten Bits der Grobspur stellen den Überlappungsbereich dar; sie sind etwa gleichwertig und aus diesen wird abgeleitet, ob die vorher beschriebenen höchstwertigen Bits vom Signal unverändert gelassen werden oder nicht.

Durch diesen Effekt wird sichergestellt, daß bei ungleichmässigen Bitübergängen in der Grob- bzw. Feinspur das Ausgangssignal nicht springt. Hierzu gibt es noch eine spezielle Maßnahme, welche dafür sorgt, daß die beiden Spuren, nämlich die Grob- und die Feinspur, in der Phase gegeneinander verschoben werden und dadurch die vier höchstwertigen Bits der Grobspur nur entweder erhöht, oder unverändert gelassen werden. Dadurch erniedrigt sich der elektronische Aufwand bei der Realisierung, weil man nur einen schaltbaren Inkrementer anstatt eines Volladdierers benötigt.

In Bild 14 ist die Zusammenfassung der einzelnen Bits mit Darstellung des Überlappungsbereichs gezeigt. Wenn m1 die gesamte Breite der feinsten Spur ist, m2 der gröberen oder Grobspur, dann ist K1,2 der Überlappungsbereich, der in der Kombinationslogik dazu führt, daß in diesem Bereich die Kombinationslogik greift und verhindert, daß Bitübergänge in diesem Bereich nicht zum Ausgang gelangen.

Man erkennt die Reduktion der Breiten der Einzelspuren auf die Gesamtbreite des Ausgangswortes, d.hj. m1 + m2 - K1,2 ist die Breite des Ausgangssignals des Systems.

Dieses Bild zeigt dann in Verallgemeinerung, daß insgesamt n-Spuren vorhanden sind, während im vorliegenden Ausführungsbeispiel nur als Ausführungsbeispiel zwei Spuren gezeigt wurden.

Man erhält z.B. bei einer 6 Bit breiten Auflösung für m1 und einer 6 Bit breiten Auflösung für m2 eine Gesamtauflösung von 10 Bit, weil der Überlappungsbereich im Bereich von 2 Bit liegt.

Dieses Auflösungsprinzip oder dieses Kombinationsprinzip ist für beliebig viele Spuren anwendbar.

Bild 15 zeigt die Draufsicht auf den Rotor in schematisierter Form mit dem Vorteil einer winkelunabhängigen Auflösung bei Erreichung einer guten Linearität.

Zum geltenden Anspruch 10 wird angemerkt, daß die Beläge nicht notwendigerweise als metallische Flächen auf einem Isolatormaterial aufgebracht werden müssen, sondern es ist in einer anderen Ausgestaltung vorgesehen, daß ein Isolatormaterial verwendet wird, welches dieselbe Kapazitätsmodulation gewährleistet. Hierunter wird verstanden, daß die Beläge des Rotors mit den darunter liegenden Volumenelementen des Rotors Volumina bilden, die mit einem anderen Dielektrikum gefüllt sind. Das heisst, diese Volumina weisen eine andere Dielektrizitätskonstante auf, als die benachbarten Volumenelemente.

ZEICHNUNGS-LEGENDE


| 1 | Stator |
| | d = Summe der Länge beider Luftspalte |
| | a = Dicke Rotor 3 |
| 2 | Stator |
| 3 | Rotor |
| 4 | Welle |
| 5 | Luftspalt ( Meßluftspalt) |
| 6 | Luftspalt (Auskoppelluftspalt) |
| 7 | Belagabschnitt (Feinspur-Stator 1) |
| 7a | Leitung |

| | |
|---|---|
| 8 | Belagabschnitt (Feinspur-Stator 1) |
| 8a | Leitung |
| 9 | Bellagabschnitt (Feinspur-Stator 1) |
| 9a | Leitung |
| 10 | Belagabschnitt (Feinspur-Stator 1) |
| 10a | Leitung |
| 11 | Belagabschnitt Feinspur (Stator 2) |
| 11a | Leitung |
| 12 | Belagabschnitt Feinspur (Stator 2) |
| 12a | Leitung |
| 13 | Belagstruktur (Rotor 3) |
| 14 | Belagstruktur (Rotor 3) |
| 15 | Oszillator |
| 16 | Leitung |
| 17 | Regler |
| 18 | Block |
| 19 | Block |
| 20 | Zähler |
| 20a | Zähler |
| 21 | Ausgänge |
| 22 | Leitung |
| 23 | Leitung |
| 24 | Block |
| 25 | Block |
| 26 | Ausgang |
| 27 | Ausgang |
| 28 | Multiplexer |
| 29 | Multiplexer |
| 30 | Ausgangsleitung |
| 31 | Ausgangsleitung |
| 32 | Verstärker |
| 33 | Demultiplexer |
| 34 | Block |
| 35 | Block |
| 37 | Eingang |
| 38 | Eingang |
| 39 | Steuerung |
| 40 | Eingang |
| 41 | Oszillator |
| 42 | Leitung |
| 43 | Leitung |
| 44 | H/u-Wandler |
| 45 | Kombinationslogik |
| 46 | Ausgabe |
| 47-50 | Leiterbahn |
| 51 | Ausnehmung |
| 52 | Beläge (Feinspur-Rotor 3 - Vorderseite) |
| 53 | Beläge (Grobspur-Rotor 3 - Vorderseite) |
| 54 | Kreisringbahnen (Auskoppelluftspalt) |
| 55 | Beläge (7-10 = Feinspur Stator 1) |
| 56 | Beläge (Grobspur Stator 1) |
| 57 | Beläge (Feinspur Rotor 3 - Rückseite) Auskoppelluftspalt 6 |
| 58 | Beläge (Feinspur Rotor 3 - Rückseite) |
| 59 | Belag (Grobspur Rotor 3 Rückseite) |
| 60 | Kontaktbahn |
| 61 | Durchkontaktierungen |
| 62 | Bereich |
| 63 | Zeiger (Figur 10) |

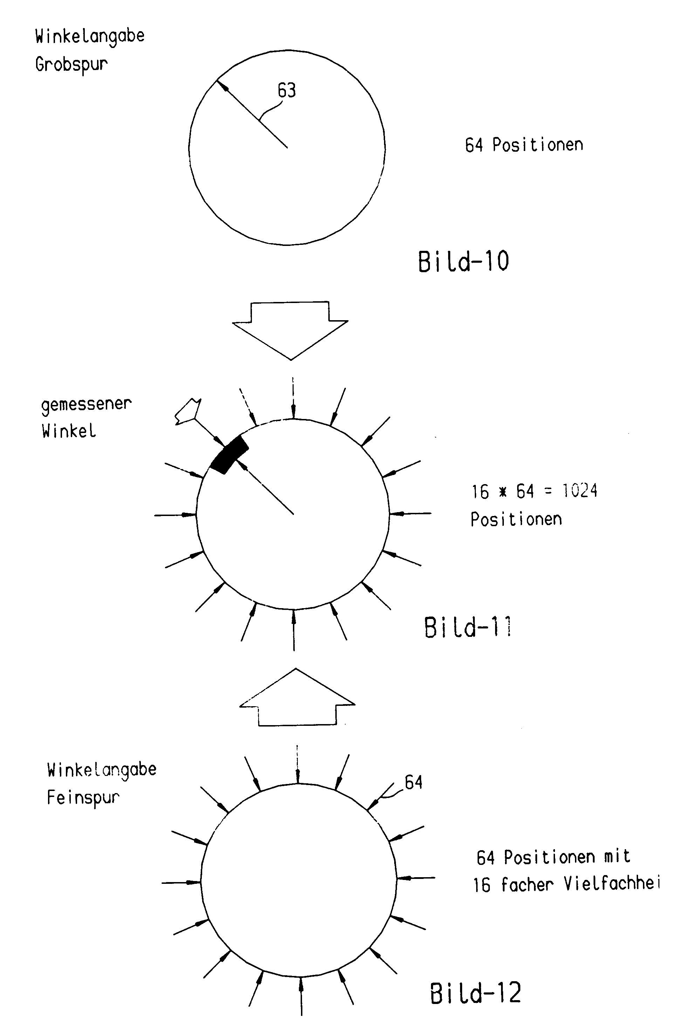

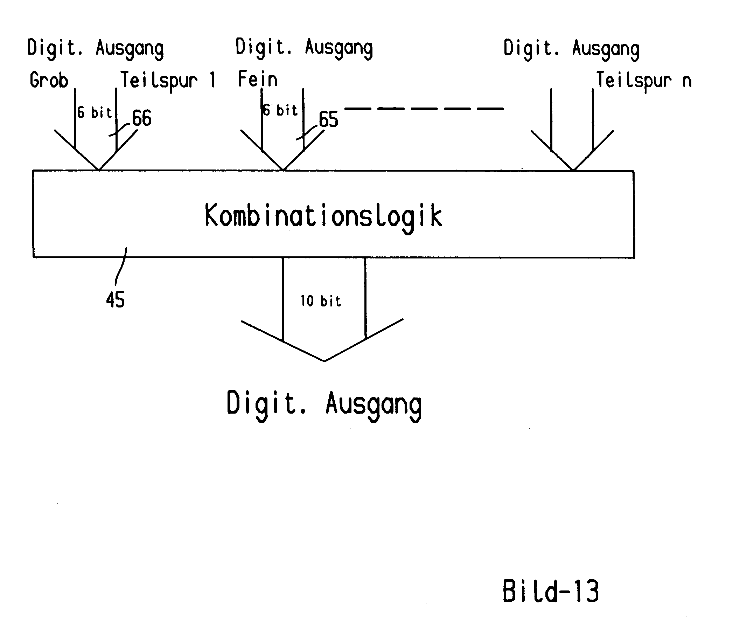

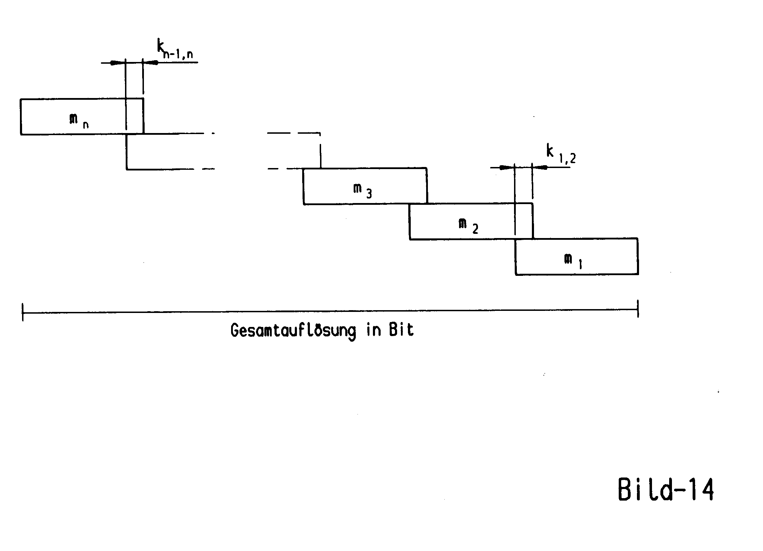

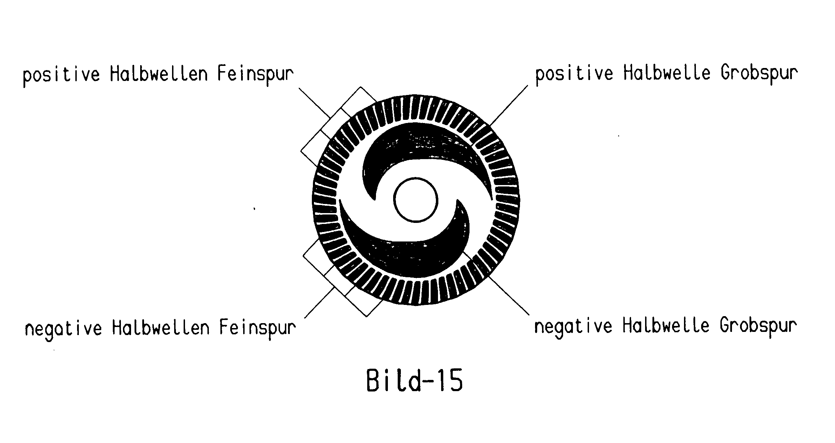

64       Zeiger (Figur 12)
65       Leitung
66       Leitung

## Patentansprüche

1. Kapazitiver Drehgeber zum Steuern und Positionieren von bewegten Gegenständen durch Weg-, Winkel- oder Geschwindigkeitsmessung des bewegten Gegenstandes, der aus zwei, einen gegenseitigen Abstand bildenden, einander gegenüberliegenden Statoren (1,2) besteht, in deren Zwischenraum ein Rotor (3) drehbar ist, der drehfest mit einer Welle (4) verbunden ist, welche mit dem bewegten Gegenstand gekoppelt ist, wobei ein erster Luftspalt (5) zwischen dem einen Stator (1) und dem Rotor (3) und ein zweiter Luftspalt (6) zwischen dem anderen Stator (2) und dem Rotor (3) gebildet ist und jeweils auf einander zugewandten Seiten der Statoren (1,2) und des Rotors (3) elektrisch leitfähige kreisringförmige, konzentrische Beläge (52,53,54,55-59) angeordnet sind, die mit dem zugeordneten Luftspalt (5,6) jeweils Kondensatoren bilden, deren Kapazitätswert mit der Drehung des Rotors (3) sich gemäss einer verlangten Funktion ändert, **dadurch gekennzeichnet,** daß die Beläge (52,53,54,55-59) so auf dem Rotor (3) und den Statoren (1,2) angeordnet sind, daß sich mindestens zwei kreisringförmige, konzentrische Bereiche ergeben, von denen der eine Bereich die Meßspur eines Großmeßsystems und der andere Bereich die Meßspur eines Feinmeßsystems bildet, wobei die Beläge (52,54,55,57,58) des Feinmeßsystems periodisch bezüglich eines Bruchteils von 360° auf kreisringförmigen Bahnen von Rotor (3) und Statoren (1,2) angeordnet sind, während die Beläge (53,54,56,59) des Großmeßsystems periodisch bezüglich 360° sind, daß die von einander zugeordneten Belägen (52,53,54,55-59) von Rotor (3) und Statoren (1,2) entstehenden Koppelkapazitäten einen Verlauf über die Verdrehung der Welle (4) aufweisen, der stückweise sinusförmig ist und daß durch Addition mehrerer gegenseitig verschobener und mit unterschiedlichem Vorzeichen versehener stückweise sinusförmig verlaufender Kapazitätsverläufe ein etwa rein sinusförmiger Kapazitätsverlauf mit einer Periode von 360°/ni entsteht, wobei ni als ganze natürliche Zahl die Polpaarzahl der jeweiligen Meßspur angibt und der Index i die Anzahl der Meßspuren durchläuft.

2. Drehgeber nach Anspruch 1, **dadurch gekennzeichnet,** daß bei Vorhandensein von einer Fein- und einer Grobspur auf einem Belag (55,56) des Stators (1) vier unterschiedliche Belagabschnitte (7-10) identischer Formgebung angeordnet sind und wobei dies für jede Art j (j von 1 bis 4) eines Belegabschnittes (7-10) gilt, daß der Belegabschnitt bezüglich eines Nullpunktwinkels um

$$j \times \frac{360°}{4 \times ni} + k \times \frac{360°}{ni} \qquad (k \text{ beliebige ganze Zahl})$$

zum jeweils anderen Belagabschnitt (7-10) verschoben ist, und daß auf dem Rotor (3) zwei Arten "1" von Belägen (52,53) um

$$1 \times \frac{360°}{2 \times ni} + k \times \frac{360°}{ni}$$

gegen einen bezüglich des Rotors (3) festen Nullpunktwinkel verschoben angeordnet sind.

3. Drehgeber nach Anspruch 2, **dadurch gekennzeichnet,** daß im Bereich des Belages (55) der Feinspur jeder Belagabschnitt (7-10) des Stators (1) mit jeweils einer folgenden Signalspannung angesteuert wird:

1.    $U_1 = U_0 \bmod \times \sin(ni \times 0)$
2.    $U_2 = U_0 \bmod \times \cos(ni \times 0)$

3. $U_3 = U_0$ mod x (- sin (ni x 0))

4. $U_4 = U_0$ mod x (- cos (ni x $\phi$))

wobei $U_0$ mod eine Modulationsspannung und $\phi$ der elektrische Winkel ist, daß die zwei Arten der Beläge (57,58,59) des Rotors (3) nach der Auskopplung auf den Stator (2) gegenphasig an einen Vorverstärker angeschlossen werden, dessen Ausgangssignal demoduliert wird und nach Umformung dem Signalverlauf

$U_{aus} = U_0$ x 2 x sin ni ( $\theta$ - $\phi$) folgt, wobei $\phi$ der mechanische Winkel ist und daß durch Veränderung von $\phi$ die Gleichung $\theta = \phi$ gilt, wobei $U_{aus}$ nur für diskrete Wert von $\phi$ zu Null geregelt wird und ansonsten die Abweichung von $\theta$ angibt.

4. Drehgeber nach Anspruch 3, **dadurch gekennzeichnet,** daß jeder Meßspur eine Spurauswerteelektronik zugeordnet ist, die innerhalb der Skalenperiode 360 ° /ni die Position mit einer Auflösung von ai bit bestimmt, wobei der elektrische Winkel $\phi$ dem mechanischen Winkel $\theta$ nachgeführt wird und der elektrische Winkel $\phi$ in dem Zähler mit a bit gespeichert wird.

5. Drehgeber nach Anspruch 4, **dadurch gekennzeichnet,** daß in einer Kombinationslogik (45) der digitale Ausgang des Grobmeßsystems mit dem digitalen Ausgang des Feinmeßsystems kombiniert wird, daß das digitale Ausgangssignal der Kombinationslogik (45) um mindestens zwei bit vermindert ist, im Vergleich zur Summe der Bitbreite beider Eingänge der Kombinationslogik, und daß bei einem 6 bit breiten digitalen Ausgang des Feinmeßsystems alle bits direkt in das 10 bit breite Ausgangssignal der Kombinationslogik übernommen werden, daß die vier höchstwertigen bits des 6 bit breiten digitalen Ausgangs des Grobmeßsystems in Abhängigkeit entweder um 1 bit erhöht, erniedrigt oder unverändert gelassen werden, sofern die Verknüpfung aus den beiden höchstwertigen Bits der Feinspur mit den beiden niederwertigsten Bits der Grobspur einen bestimmten Wert einnehmen.

6. Drehgeber nach Anspruch 1, **dadurch gekennzeichnet,** daß der Rotor (3) und die Statoren (1,2) aus einem isolierenden Material gebildet sind und
daß die Beläge (52,53,54,55-59) und alle übrigen leitfähigen Elemente aus leitfähigem Material gebildet sind und daß die elektrischen Verbindungen zwischen den Belägen der Vorder- und Rückseite von Rotor (3) und Statoren (1,2) mittels das isolierende Material durchsetzenden Durchkontaktierungen (61) gebildet sind.

7. Drehgeber nach Anspruch 6, **dadurch gekennzeichnet,** daß auf der einen Seite des Stators (1) vier spiralförmige Leiterbahnen (47-50) angeordnet sind, die mit zugeordneten Leitungen (7a- 10a) verbunden sind, und daß die Leiterbahnen (47-50) über Durchkontaktierungen mit den auf der anderen Seite des Stators angeordneten Belagabschnitten (7-10) des Belages (55) der Feinspur in der Weise verbunden sind, daß bei vier vorhandenen unterschiedlich gepolten Belagabschnitten (7-10) jedem Belagabschnitt eine Signalspannung ($U_1$ - $U_4$) zugeführt wird.

8. Drehgeber nach Anspruch 7 , **dadurch gekennzeichnet,** daß die der Feinspur zugeordnete Belegungsdichte der Belagabschnitte (7-10) des Belages (55) des Stators (1) konstant ist und daß die den Belagabschnitten (7-10) des Stators (1) gegenüberliegenden Beläge (52) auf der Vorderseite des Rotors (3)eine Belegungsdichte entsprechend einer Sinusfunktion aufweisen, und daß die Überlappungsflächen der einander gegenüberliegenden Beläge (52,55) von Rotor (3) und Stator (1) sich bei Verdrehung der Welle (4) stückweise sinusförmig ändern.

9. Drehgeber nach Anspruch 7 und 8 , **dadurch gekennzeichnet,** daß auf der Rückseite des Rotors (3) im Bereich der Feinspur zwei radial zueinander versetzte Kreisringe mit darauf angeordneten, elektrisch voneinander getrennten Belägen (57,58) angeordnet sind, deren radiale Länge mit der radialen Länge der auf der Vorderseite angeordneten Beläge (52) übereinstimmt, daß jeder gleichpolige Belegabschnitt (7-10) des Belages (55) mit einem Element des Belages (57) verbunden ist und daß jeder anderspolige Belagabschnitt (7-10) des Belages (55) mit jeweils einem Element des Belages (58) verbunden ist.

10. Drehgeber nach Anspruch 1, **dadurch gekennzeichnet,** daß die Beläge (52,53,54,55-59) aus einem isolierenden Material andere, vorzugsweise höherer, Dielektrizitätskonstante gebildet sind als vergleichsweise das Material der übrigen Flächen des Rotors (3).

**11.** Drehgeber nach Anspruch 1, **dadurch gekennzeichnet,** daß zur Beseitigung eines Verkippungs- und/oder Exzentrizitätsfehlers auf dem Rotor (3) im Bereich der Feinspur die auf der Vorderseite in gegenseitigem Abstand angeordneten Beläge (52) gleicher Polarität voneinander isoliert sind, und jeweils mit auf der Rückseite zugeordneten Belägen (57,58) einzeln verbunden sind.

**Claims**

**1.** A capacitive rotary transmitter for controlling and positioning moving objects through the measurement of the path, angle or speed of the moving object, which consists of two stators (1,2), lying opposite each other and forming a reciprocal distance, in the intermediate space of which a rotor (3) is rotatable, which is connected with a shaft (4) so as to be fixed with regard to rotation, which shaft is coupled with the moving object, in which a first air gap (5) is formed between one stator (1) and the rotor (3) and a second air gap (6) is formed between the other stator (2) and the rotor (3) and in each case on sides of the stators (1,2) which face each other, and of the rotor (3), there are arranged electrically conductive, concentric coverings (52,53,54,55-59) in the shape of a circular ring, which coverings with the associated air gap (5,6) in each case form capacitors, the value of capacitance of which changes with the rotation of the rotor (3) according to a required function,
characterised in that
the coverings (52,53,54,55-59) are arranged on the rotor (3) and on the stators (1,2) such that at least two concentric regions are produced, in the shape of a circular ring, one region of which forms the measurement track of a large-scale measurement system and the other region forms the measurement track of a precision measurement system, in which the coverings (52,54,55,57,58) of the precision measurement system are arranged periodically with regard to a fraction of 360° on paths, of circular ring shape, of rotor (3) and stators (1,2), whilst the coverings (53,54,55,59) of the large-scale measurement system are periodic with regard to 360°, that the coupling capacitances arising from coverings (52,53,54,55-59) of rotor (3) and stators (1,2), which are associated with each other, have a path over the rotation of the shaft (4) which is sinusoidal piece by piece and that through the addition of a plurality of capacitance paths, running sinusoidally piece by piece, reciprocally displaced and provided with different signs, an approximately purely sinusoisal capacitance path with a period of 360° /ni is produced, in which ni as a whole natural number indicates the number of the pair of poles of the respective measurement track and the index i runs through the number of measurement tracks.

**2.** A rotary transmitter according to Claim 1,
characterised in that
in the presence of a precision- and of a coarse track on covering (55,56) of the stator (1) four different covering sections (7-10) of identical shape are arranged and in which this applies for each type j (j from 1 to 4) of a covering section (7-10), that the covering section with respect to a zero point angle is displaced by

$$j \times \frac{360°}{4 \times ni} + k \times \frac{360°}{ni} \text{(k any whole number)}$$

to the other respective covering section (7-10), and that on the rotor (3) two types "1" of coverings (52,53) are arranged so as to be displaced by

$$1 \times \frac{360°}{2 \times ni} + k \times \frac{360°}{ni}$$

towards a zero point angle which is fixed with respect to the rotor (3).

**3.** A rotary transmitter according to Claim 2,
characterised in that
in the region of the covering (55) the precision track of each covering section (7-10) of the stator (1) is controlled by respectively a signal voltage as follows:

1. $U_1 = U_0$ mod x sin (ni x 0)
2. $U_2 = U_0$ mod x cos (ni x 0)
3. $U_3 = U_0$ mod x (-sin (ni x 0)
4. $U_4 = U_0$ mod x (-cos (ni x $\phi$))

in which $U_0$ mod is a modulation voltage and $\phi$ is the electrical angle, that the two types of coverings (57,58,59) of the rotor (3) after the decoupling onto the stator (2) are connected in phase opposition to a pre-amplifier, the output signal of which is demodulated and after conversion follows the signal pattern

$$U_{aus} = U_0 \times 2 \times \sin \text{ni} ( \theta - \phi)$$

In which $\theta$ is the mechanical angle and that through alteration of $\phi$ the equation $\theta = \phi$ applies, in which $U_{aus}$ is only regulated for discrete value from $\phi$ to zero and otherwise indicates the deviation from $\theta$.

**4.** A rotary transmitter according to Claim 3,
characterised in that
each measurement track has associated with it track evaluation electronics, which determine within the scale period 360° /ni theposition with a resolution of ai bit, in which the electrical angle $\phi$ follows the mechanical angle $\theta$ and the electrical angle $\phi$ is stored in the counter with a bit.

**5.** A rotary transmitter according to Claim 4,
characterised in that
in a combination logic (45) the digital output of the coarse measurement system is combined with the digital output of the precision measurement system, that the digital output signal of the combination logic (45) is reduced by at least two bit, compared with the sum of the bit width of the two inputs of the combination logic, and that with 6 bit wide digital output of the precision measurement system all the bits are taken over directly into the 10 bit wide output signal of the combination logic, that the four bits of highest value of the 6 bit wide digital output of the coarse measurement system in dependence are either increased by 1 bit, lowered or left unchanged, in so far as the combination of the two bits of highest value of the precision track with the two bits of lowest value of the coarse track assume a particular value.

**6.** A rotary transmitter according to Claim 1,
characterised in that
the rotor (3) and the stators (1,2) are formed from an insulating material and that the coverings (52,53,54,55-59) and all other conductive elements are formed from conductive material and that the electrical connections between the coverings and the front- and rear side of rotor (3) and stators (1,2) are formed by means of through contacts (61) penetrating the insulating material.

**7.** A rotary transmitter according to Claim 6,
characterised in that
on one side of the stator (1) four spiral-shaped conductor paths (47-50) are arranged, which are connected with associated lines (7a - 10a), and that the conductor paths (47-50) are connected via through contacts with the coverings sections (7-10) of the covering (55) of the precision track, arranged on the other side of the stator, such that when four differently poled covering sections (7-10) are present, a signal voltage ($U_1$ - $U_4$) is supplied to each covering section.

**8.** A rotary transmitter according to Claim 7,
characterised in that
the covering density of the covering sections (7-10) of the covering (55) of the stator (1), associated with the precision track, is constant and that the coverings (52) lying opposite the covering sections (7-10) of the stator (1) on the front side of the rotor (3) have a covering density corresponding to a sine function, and that the overlapping surfaces of the coverings (52,55), lying opposite each other, of rotor (3) and stator (1) alter sinusoidally piece by piece on rotation of the shaft (4).

9. A rotary transmitter according to Claim 7 and 8,
characterised in that
on the rear side of the rotor (3) in the region of the precision track, two circular rings are arranged, which are displaced radially with respect to each other, with coverings (57,58) arranged thereon and separated electrically from each other, the radial length of which coincides with the radial length of the coverings (52) arranged on the front side, that each homopolar covering section (7-10) of the covering (55) is connected with an element of the cover (57) and that each heteropolar covering section (7-10) of the covering (55) is connected with in each case an element of the covering (58).

10. A rotary transmitter according to Claim 1,
characterised in that
the coverings (52,53,54,55-59) are formed from an insulating material of a different, preferably higher, dielectric constant than, by comparison, the material of the other surfaces of the rotor (3).

11. A rotary transmitter according to Claim 1,
characterised in that
to eliminate a tilting- and/or eccentricity error on the rotor (3) in the region of the precision track, the coverings (52) of the same polarity, arranged at reciprocal distance on the front side, are insulated from each other and in each case are connected individually with associated coverings (57,58) on the rear side.

**Revendications**

1. Transmetteur rotatif capacitif pour la commande et le positionnement d'objets en mouvement au moyen de la mesure de déplacement, de l'angle ou de la vitesse de l'objet en mouvement, constitué de deux stators (1, 2) espacés l'un de l'autre en se faisant face, dans l'espace desquels un rotor (3) est en rotation, lequel est fixé sur un arbre (4) couplé avec l'objet en mouvement, une première fente d'air (5) étant prévue entre le stator (1) et le rotor (3,) et une deuxième fente d'air (6) étant prévue entre le stator (2) et le rotor (3), des armatures concentriques (52, 53, 54, 55 à 59) à pouvoir conducteur électrique de forme annulaire étant montées sur les côtés se faisant face des stators (1, 2) et du rotor (3), lesquelles forment respectivement des condensateurs avec la fente d'air associée (5,6), dont la valeur capacitive se modifie avec la rotation du rotor selon une fonction demandée, caractérisé en ce que les armatures (52, 53, 54, 55 à 59) sont montées sur le rotor (3) et sur les stators (1,2), de façon à former au moins deux sections concentriques de forme annulaire, dont une section constitue la piste de mesure d'un système de mesure grossier, et l'autre section la piste de mesure d'un système de mesure de précision, les armatures (52, 54, 55, 57, 58) du système de mesure de précision étant disposées sur des pistes de forme annulaire du rotor (3) et des stators (1,2), périodiquement sur une fraction de 360°, alors que les armatures (53, 54, 56, 59) du système de mesure grossier sont disposées périodiquement sur 360°, en ce que les capacités de couplage, engendrées par les armatures (52, 53, 54, 55 à 59) du rotor (3) et des stators (1, 2), associées les unes aux autres, présentent une variation suivant la position angulaire de l'arbre (4), laquelle est sinusoïdale par endroits, et en ce que par l'addition de plusieurs variations de capacité réciproquement décalées évoluant de façon sinusoïdale par endroits, et affectées de signes différents, il est obtenu une variation de capacité presque purement sinusoïdale ayant une période de 360°/ni, ni indiquant, en tant que nombre entier naturel, le nombre de paires de pôles de la piste de mesure concernée, et l'indice i étant l'itération correspondant au nombre de pistes de mesure.

2. Transmetteur selon la revendication 1, caractérisé en ce que, compte tenu de l'existence d'une piste de précision et d'une piste grossière, quatre sections d'armatures différentes (7 à 10) de forme identique sont disposées sur une armature (55, 56) du stator (1), ceci étant valable pour chaque type j (j de 1 à 4) d'une section d'armature (7 à 10), en ce que la section d'armature est décalée par rapport à l'angle zéro de

$$j \ x \ \frac{360°}{4 \ x \ ni} \ + \ k \ x \ \frac{360°}{ni}$$

(k étant n'importe quel nombre entier)

et en ce que deux autres types "1" d'armatures (52, 53) sont disposés sur le rotor (3), décalés par rapport à l'autre section respective d'armatures (7 à 10) de

$$1 \ x \ \frac{360°}{2 \ x \ ni} \ + \ k \ x \ \frac{360°}{ni}$$

par rapport à un angle zéro fixe du rotor (3).

3. Transmetteur selon la revendication 2, caractérisé en ce que dans la zone de l'armature (55) de la piste de précision, chaque section d'armature (7 à 10) du stator (1) est soumise à une des tensions de signalisation ci-après :

1. $U_1 = U_0 \text{ mod } x \sin(ni \ x \ \phi)$
2. $U_2 = U_0 \text{ mod } x \cos(ni \ x \ \phi)$
3. $U_3 = U_0 \text{ mod } x \ (- \sin(ni \ x \ \phi))$
4. $U_x = U_0 \text{ mod } x \ (- \cos(ni \ x \ \phi))$

$U_0$ mod étant la tension de modulation et $\phi$ l'angle électrique, et en ce que les deux types d'armatures (57, 58, 59) du rotor (3) sont raccordées en opposition de phase, après découplage au niveau du stator (2), à un amplificateur dont le signal de sortie est démodulé, et qui après conversion du signal, suit la fonction de signalisation

$U_{sortie} = U_0 \ x \ 2 \ x \sin ni \ (\theta - \phi)$, $\theta$ étant l'angle mécanique, et en ce que, par la modification de $\phi$ l'équation $\theta = \phi$ s'applique, Usortie n'étant réglée à zéro que pour des valeurs discrètes de $\theta$, et indiquant sinon l'écart de $\theta$.

4. Transmetteur selon la revendication 3, caractérisé en ce qu'un dispositif électronique d'évaluation est associé à chaque piste de mesure, lequel détermine la position dans la période scalaire de 360°/ni avec une résolution de ai bit, l'angle électrique $\phi$ étant évalué après l'angle mécanique $\theta$, et l'angle électrique $\phi$ étant mémorisé dans le compteur par a bit.

5. Transmetteur selon la revendication 4, caractérisé en ce que la sortie numérique du système de mesure grossier est combinée avec la sortie numérique du système de mesure de précision dans une logique de combinaison (45), en ce que le signal de sortie numérique de la logique de combinaison (45) est réduit d'au moins deux bits par rapport à la largeur de bits de la somme des deux entrées de la logique de combinaison, et en ce que, lors de la sortie numérique codée sur 6 bits du système de mesure de précision, tous les bits sont directement repris par le signal de sortie codé sur 10 bits de la logique de combinaison, laquelle, soit augmente d'1 bit les quatre bits de poids fort du signal de sortie numérique codé sur 6 bits du système de mesure grossier, soit les diminue ou les laisse inchangés, dans la mesure où l'enchaînement logique résultant des deux bits de poids fort de la piste de précision prend une certaine valeur avec les deux bits de poids faible de la piste grossière.

6. Transmetteur selon la revendication 1, caractérisé en ce que le rotor (3) et les stators (1,2) sont réalisés en matériau isolant, en ce que les armatures (52, 53, 54, 55 à 59) et tous les autres éléments conducteurs sont réalisés en matériau conducteur, et en ce que les liaisons électriques entre les armatures des côtés avant et des côtés arrière du rotor (3) et des stators (1, 2), sont réalisés par des contacts métallisés (61) traversant le matériau isolant.

7. Transmetteur selon la revendication 6, caractérisé en ce qu'un côté du stator (1) est équipé de quatre pistes conductrices de forme spiralée (47 à 50) reliées par des liaisons associées (7a à 10a), et en ce que les pistes conductrices (47 à 50) sont reliées par des contacts métallisés aux sections d'armatures (7 à 10) de l'armature (55) de la piste de précision se trouvant de l'autre côté du stator, de telle façon qu'en présence de quatre sections d'armatures (7 à 10) de polarité différente, chaque armature soit alimentée par une tension de signalisation ($U_1$ à $U_4$).

8. Transmetteur selon la revendication 7, caractérisé en ce que la densité des sections d'armatures (7 à 10) de l'armature (55) du stator (1) associée à la piste de précision est constante, en ce que les armatures (52) sur le côté avant du rotor (3) situées en face des sections d'armatures (7 à 10) du stator (1), ont une densité correspondant à une fonction sinus, et en ce que les surfaces de recouvrement des armatures (52, 55) du rotor (3) et du stator (1), se faisant face, se modifient de façon sinusoïdale par endroits suivant la position angulaire de l'arbre (4).

9. Transmetteur selon les revendications 7 et 8, caractérisé en ce que, dans la zone de la piste de précision, le côté arrière du rotor (3) est équipé de deux éléments annulaires radialement décalés, sur lesquels sont disposés deux armatures (57, 58) séparées électriquement l'une de l'autre, dont la longueur circonférentielle correspond à la longueur circonférentielle des armatures (52) équipant le côté avant, en ce que chaque section d'armatures (7 à 10) de même polarité de l'armature (55) est reliée à un élément de l'armature (57), et en ce que chaque section d'armatures (7 à 10) de polarité différente de l'armature (55), est respectivement reliée à un élément de l'armature (58).

10. Transmetteur selon la revendication 1, caractérisé en ce que par comparaison aux autres surfaces du rotor (3), les armatures (52, 53, 54, 55 à 59) sont réalisées en matériau isolant d'une constante diélectrique différente, de préférence plus élevée.

11. Transmetteur selon la revendication 1, caractérisé en ce que, pour éviter tout défaut de basculement et/ou d'excentricité dans la zone de la piste de précision du rotor (3), les armatures (52) de même polarité, disposées sur le côté avant, sont isolées les unes des autres et reliées individuellement aux armatures (57, 58) associées du côté arrière, auxquelles elles sont opposées à une certaine distance.

Bild-1

55

13 14

Steuersignal

Oszillator

(Zustand)

7a   sin (Zustand)   7
8a   cos (Zustand)   8
9a   -sin (Zustand)   9
10a  -cos (Zustand)  10

Rotor

11   E₁   11a
12   E₂   12a

Empfänger
Regler

Steuersignal

16        15        1 5        3        6 2        17

Bild-2

Bild-3

Bild-4

Bild-5

Bild-6

EP 0 258 725 B1

EP 0 258 725 B1

Bild-7

EP 0 258 725 B1

| 9 | 8 | 7 | 10 | 9 | 8 |

Bild 8a

$E_1$     53

$(-E_2)$

62

Bild 8b

$E_1$   +

$E_2$   −

S

Bild 8c

Fehler = Verstärkung * ( E1- E2 )

Fehler (el. Winkel, mech. Winkel) = Amplitude * sin (el. Winkel − mech. Winkel -Versatz)

Bild 8d

Bild-8

$$U(\frac{d}{dt} \text{ mech.Winkel})$$

mech. Winkel → | codierte Scheibe | —2/→ | Auswertung Subtraktion | —1/Error→ | Regler | → | Geschw. |

1,2,3   32,33   34

Takt Generator —41

| Signal-formung | ← | Zähler el. Winkel | Logik | Richtungs-Logik |

24,25   20   15   35

Digitaler Ausgang

Bild-9

EP 0 258 725 B1

Winkelangabe
Grobspur

63

64 Positionen

Bild-10

gemessener
Winkel

16 * 64 = 1024
Positionen

Bild-11

Winkelangabe
Feinspur

64

64 Positionen mit
16 facher Vielfachhei

Bild-12

EP 0 258 725 B1

Digit. Ausgang    Digit. Ausgang    Digit. Ausgang

Grob    Teilspur 1    Fein    Teilspur n

6 bit    66    6 bit    65 — — — —

Kombinationslogik

45    10 bit

Digit. Ausgang

Bild-13

Bild-14

$m_1$

$m_2$

$m_3$

$m_n$

$k_{1,2}$

$k_{n-1,n}$

Gesamtauflösung in Bit

positive Halbwelle Grobspur

negative Halbwelle Grobspur

positive Halbwellen Feinspur

negative Halbwellen Feinspur

Bild-15

33